(19) Europäisches Patentamt
European Patent Office
Office européen des brevets

(11) **EP 4 202 580 B1**

(12) **EUROPÄISCHE PATENTSCHRIFT**

(45) Veröffentlichungstag und Bekanntmachung des Hinweises auf die Patenterteilung:
**19.03.2025 Patentblatt 2025/12**

(21) Anmeldenummer: **22213866.1**

(22) Anmeldetag: **15.12.2022**

(51) Internationale Patentklassifikation (IPC):
*H01H 9/16* (2006.01)    *H01H 9/22* (2006.01)
*G05B 9/03* (2006.01)    *H03K 19/007* (2006.01)

(52) Gemeinsame Patentklassifikation (CPC):
**G05B 9/03; H03K 19/0075;** H01H 9/167;
H01H 9/226

(54) **SENSORSCHALTUNG FÜR EINE EINE SICHERHEITSFUNKTION AUSFÜHRENDE VORRICHTUNG, VORRICHTUNG UND VERFAHREN ZUM VERARBEITEN VON MESSWERTEN VON SENSOREN**

SENSOR CIRCUIT FOR A DEVICE CARRYING OUT A SAFETY FUNCTION, DEVICE AND METHOD FOR PROCESSING MEASURED VALUES OF SENSORS

CIRCUIT DE CAPTEUR POUR UN DISPOSITIF D'EXÉCUTION D'UNE FONCTION DE SÉCURITÉ, DISPOSITIF ET PROCÉDÉ DE TRAITEMENT DE VALEURS DE MESURE DE CAPTEURS

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **21.12.2021 DE 102021134163**

(43) Veröffentlichungstag der Anmeldung:
**28.06.2023 Patentblatt 2023/26**

(73) Patentinhaber: **Abberior Instruments GmbH**
**37077 Göttingen (DE)**

(72) Erfinder: **Kastrup, Lars**
**37073 Göttingen (DE)**

(56) Entgegenhaltungen:
DE-A1- 1 537 379        DE-A1- 10 330 202
DE-A1- 102013 108 532        US-A1- 2020 195 186

## Beschreibung

### Technisches Gebiet der Erfindung

Die Erfindung betrifft eine Sensorschaltung für eine eine Sicherheitsfunktion ausführende Vorrichtung, eine entsprechende Vorrichtung sowie ein Verfahren zum Verarbeiten von Messwerten von Sensoren.

Als Sicherheitsfunktionen werden im Kontext der vorliegenden Anmeldung solche Funktionen bezeichnet, die dazu ausgelegt sind, Personen vor Verletzungen oder anderen Beeinträchtigungen der Gesundheit durch verschiedenste technische Einrichtungen zu schützen, oder weitergehende Beschädigungen an Anlagen, Gebäuden, etc. zu verhindern.

Nach dem Stand der Technik sind Sensorsysteme bekannt, die den Status von Sicherheitsfunktionen ausführenden Vorrichtungen überwachen. Diese können z.B. Zustände erkennen, in dem die Vorrichtung ihre Sicherheitsfunktion nur unzureichend oder gar nicht mehr ausführt. Durch Kopplung des Sensors mit Sicherheitsschaltkreisen kann dann z.B. bei Erkennung eines unsicheren Zustands eine Notabschaltung herbeigeführt werden.

So können z.B. Maschinen, die elektrisch, pneumatisch oder hydraulisch angetriebene Elemente aufweisen, eine Abdeckung oder ein Gehäuse aufweisen, um insbesondere Bediener der Maschine vor Verletzungen zu schützen.

Sicherheitsrelevante Abdeckungen und Gehäuse sind ebenfalls z.B. bei optischen Geräten bekannt, die z.B. Hochleistungs-Laser enthalten. In diesem Fall gewährleistet die Abdeckung die Lasersicherheit, indem sie Bediener und andere anwesende Personen vor einer Schädigung der Augen durch das Laserlicht schützt.

Um z.B. Wartungsarbeiten durchführen zu können, sind solche Abdeckungen jedoch häufig mit einem Öffnungsmechanismus versehen.

Damit eine unvorhergesehene Öffnung der Abdeckung keine Gefahr darstellt, können Sensorsysteme (z.B. mechanisch oder magnetisch ausgelöste Schalter oder durch Magnete ausgelöste Hall-Sensoren) den Öffnungszustand der Abdeckung kontrollieren und im offenen Zustand einen Übergang in einen sicheren Zustand (z.B. eine Notabschaltung oder einen Übergang in einen Standby-Zustand) bewirken.

Weiterhin besteht z.B. bei optischen Geräten wie Lichtmikroskopen, welche insbesondere Laserquellen verwenden, das Problem, dass bei einer notwendigen mechanischen Verstellung von optischen Elementen wie Spiegeln oder Filteranordnungen im Strahlengang Reflexe des Laserlichts in das Okular gelangen können. Dies kann zu Augenschädigungen des Benutzers führen. Aus diesem Grund sind z.B. Sicherheitssensoren bekannt, die bestimmte sicherheitskritische Anordnungen der optischen Elemente im Strahlengang erkennen und daraufhin verhindern, dass Lichtreflexe im Okular auftreten, etwa durch Abdunklung des Okulars oder gezieltes Unterbrechen oder Umlenken des Laserlichts an geeigneter Stelle.

Zur weiteren Steigerung der Sicherheit auch im Fall von Fehlfunktionen des Sicherheitssystems ist beispielsweise gemäß der Norm DIN EN 61508-2:2010 vorgeschrieben, Sicherheitsfunktionen ausführende Systeme redundant auszuführen. Dazu können z.B. mindestens zwei Sensoren vorgesehen sein, welche dieselbe Sicherheitsfunktion überwachen. Die mindestens zwei Sensoren können dabei dieselbe physikalische Messgröße oder unterschiedliche physikalische Messgrößen erfassen, über die sich eine Aussage über den Zustand des Sicherheitssystems treffen lässt.

Weiterhin ist es aus dem Stand der Technik bekannt, solche redundanten Sensoren antivalent (z.B. über antivalente Datenleitungen) mit einem Überwachungsschaltkreis zu koppeln. Dabei bedeutet "antivalent", dass sich die Signalpegel der Ausgangssignale der Sensoren bei gleichem Zustand des Sicherheitsfunktionen ausführenden Systems voneinander unterscheiden. Beispielsweise kann ein erster Sensor bei geschlossener Abdeckung ein Ausgangssignal niedriger elektrischer Spannung (LO) und bei geöffneter Abdeckung ein Ausgangssignal hoher Spannung (HI) erzeugen, während ein zweiter Sensor bei geschlossener Abdeckung ein Ausgangssignal hoher Spannung (HI) und im geöffneten Zustand ein Signal niedriger Spannung (LO) ausgibt.

Ein solches Überwachungssystem hat den Vorteil, dass es definierte erlaubte Zustände hat, nämlich diejenigen, bei denen die Sensor-Ausgangssignale einen unterschiedlichen Signalpegel (HI/LO oder LO/HI) aufweisen, während Zustände mit zwei gleichen Signalpegeln (LO/LO oder HI/HI) unzulässig sind und als Fehler interpretiert werden. Infolge von unerlaubten Zuständen kann dann z.B. durch den Überwachungsschaltkreis automatisch eine Notabschaltung des Systems oder der Übergang in einen sicheren Zustand eingeleitet werden.

Sicherheitsrelevante Systeme mit redundanten Sensoren haben den Nachteil, dass kurzzeitige unzulässige Zustände (Zustände gleichen Signalpegels beider Sensoren) häufig dadurch entstehen, dass die Sensoren bei einer Veränderung ihrer Messgröße nicht gleichzeitig auslösen. Infolgedessen werden z.B. unnötige Notabschaltungen oder Übergänge in sichere Zustände herbeigeführt, obwohl gar kein sicherheitsrelevantes Problem vorhanden ist.

### Stand der Technik

Die US-Patentschrift Nr. 4,088,900 offenbart eine Schaltung zum Auswerten von sicherheitsrelevanten Signalen bei der Steuerung eines Aufzugs. Die Schaltung umfasst einen Schaltkreis, eine Überwachungsschaltung und eine Prüfschaltung, die über Dioden miteinander gekoppelt sind. Die drei Teilschaltungen weisen jeweils zwei unterschiedliche digitale logische Einheiten auf. Die beiden logischen Elemente des Schaltkreises erhalten antivalente Signale zweier Sensoren, die den Zustand der Tür des Aufzugs überwachen. Durch die Überwachungsschaltung und die Prüfschaltung können unterschiedliche Fehlerzustände erkannt werden und es kann daraufhin das Ingangsetzen des Aufzugsmotors blockiert werden. Um zu verhindern, dass das System bei nur für kurze Zeit auftretender Äquivalenz der Sensorsignale nicht abgeschaltet wird, ist eine Verzögerungsschaltung vorgesehen.

Die US-Patentanmeldung 2005/0052083 A1 beschreibt ein Verfahren zum Erkennen von fehlerhaften antivalenten Schlüssel- oder Schaltsignalen und eine entsprechende Schaltung zur Durchführung des Verfahrens. Gemäß dem dargestellten Ausführungsbeispiel werden die antivalenten Signalausgänge in einer Auswerteeinheit in zwei parallelen Zweigen zu logischen UND-Gattern geführt, wobei in einem der Zweige ein Inverter-Glied angeordnet ist, so dass bei fehlerhaften äquivalenten Zuständen der zwei Signalausgänge ein Fehlersignal generiert wird. Durch eine Verzögerungsschaltung wird sichergestellt, dass kurzzeitige äquivalente Zustände nicht in einem Fehlersignal resultieren. In einer Variante des Verfahrens kann über eine weitere Verzögerungsschaltung erkannt werden, ob das Schlüssel- oder Schaltsignal über eine zu lange Dauer anliegt, ein Fehler der z.B. durch das Blockieren einer Eingabetaste entstehen kann. Weiterhin offenbart die Patentanmeldung die Verwendung des Verfahrens in verschiedenen Produktionsmaschinen.

Aus der Patentschrift DE 43 15 298 C1 ist eine Schaltungsanordnung zur Erzeugung zweier zueinander komplementärer Signale bekannt, bei der ein Signal und ein dazu invertiertes Signal an je einen von einem Takt gesteuerten Transfertransistor angelegt sind, wobei jeder Transfertransistor ausgangsseitig einen Inverter steuert, und wobei die Inverter kreuzweise rückgekoppelt sind. Dadurch lässt sich die Übereinstimmung des Zeitverhaltens der antivalenten Signale verbessern.

Die europäische Patentschrift EP 0 164 118 B1 beschreibt eine Schaltung zur Auswertung des Signals eines Hall-Sensors mit antivalenten Ausgangssignalen, der den Zustand eines Gleichstrommotors für eine Computer-Festplatte überwacht. Die Schaltung weist einen Kommutationskomparator und einen Indexkomparator auf, wobei der Ausgang des Kommutationskomparators gemäß einer Ausführungsform mit einem Eingang des Indexkomparators dynamisch gekoppelt ist, so dass eine positive Flanke des Ausgangssignals mit einem Nulldurchgang des Sensorsignals mit hoher Genauigkeit koordiniert wird.

Die im Stand der Technik beschriebenen Lösungen richten sich auf die bessere zeitliche Koordination der antivalenten Signale selbst (z.B. durch Verzögerungsschaltungen) und haben damit den Nachteil, dass bei nicht perfekter Synchronisation in bestimmten Situationen immer noch kurzzeitige Signal-Äquivalenz eintreten kann und somit unerwünschte Fehlerzustände auftreten können.

Die DE 103 30 202 offenbart eine Wegsensorvorrichtung mit zwei magnetoresistiven Elementen zur Abtastung von magnetischen Encodern mit Messbrücken mit Messsignalverstärkern, welche das Signal der Brücken verstärken und Komparatoren bzw. Analog-Digital-Wandlern zur Umwandlung der analogen Wechselsignale in Digitalsignale. Weiterhin ist eine Umschalteinrichtung vorgesehen, welche den Strom in einer Messbrücke zur Erhöhung der Genauigkeit und des Störabstandes verändern kann. Die Wegsensorvorrichtung weist außerdem Spannungsfolger auf, die mit einem Mittenpotential der jeweiligen Messbrücke und dem Referenzpotential eines Komparators bzw. Analog-Digital-Wandlers verbunden sind, welche das Referenzpotential auf die jeweilige Messbrücke beziehen.

In der DE 10 2013 108 532 A1 ist ein Feldgerät zur Füllstandanzeige von Flüssigkeiten beschrieben. In einem Anschlussstecker des Feldgeräts sind Anzeigeelemente vorgesehen, von denen zwei Anzeigeelemente antivalente Schaltausgänge des Feldgeräts signalisieren. Ein weiteres Anzeigeelement zeigt eine Stör- und/oder Fehlfunktion des Feldgeräts an. Das Anzeigeelement zum Anzeigen der Stör- und/oder Fehlfunktion wird durch eine NOR-_ oder XNOR-Schaltung gesteuert, mit welcher die antivalenten Schaltausgänge verarbeitet werden.

Aus der US 2020/0195186 A1 ist eine Steuerschaltung für eine Inverter-Vorrichtung bekannt, die einen Motor antreibt, indem sie eine AC-DC-Umwandlung durch eine Brückenschaltung durchführt. Die Steuerschaltung weist eine Sicherheitsschaltung mit zwei Komparatoren und einer Verknüpfungseinheit auf. Die Komparatoren vergleichen jeweils einen DC-Spannungsmesswert und eine Ausgangsspannung einer isolierten Spannungsquelle mit jeweiligen Referenzwerten. Die Verknüpfungseinheit verknüpft die Ausgänge der Komparatoren mit einer UND-Operation.

Die DE 15 37 379 A1 beschreibt eine Sicherheitsschaltung zum Durchführen logischer Verknüpfungen, insbesondere für das Eisenbahnsicherungswesen. Die Sicherheitsschaltung enthält ein NAND-Glied und ein NOR-Glied mit je einem Ausgang für binäre Schaltvariablen und deren antivalente Schaltvariablen in Form von rechteckförmigen digitalen Signalen mit vorgegebener Folgefrequenz. An die Ausgänge der beiden Verknüpfungsglieder ist als Überwachungsglied eine Gleichrichterschaltung angeschlossen, deren Ausgangsspannung als Versorgungsspannung für die Schaltstrecke eines elektronischen Schalters verwendet wird, für dessen Steuerstrecke rechteckförmige digitale Testsignale mit mindestens der doppelten vorgegebenen Folgefrequenz vorgesehen sind, die außerhalb des Flankenbereichs der digitalen Signale liegen.

**Aufgabe der Erfindung**

Die vorliegende Erfindung hat die Aufgabe, eine Sensorschaltung für eine eine Sicherheitsfunktion ausführende Vorrichtung mit redundanten Sensoren zur Verfügung zu stellen, bei der seltener prinzipbedingte, vorübergehende Fehlerzustände auftreten, was die Benutzerfreundlichkeit und Ausfallsicherheit der Sensorschaltung bzw. der Vorrichtung verbessert.

**Lösung**

Diese Aufgabe wird durch die Sensorschaltung gemäß Anspruch 1, die Vorrichtungen nach Anspruch 12 und 13, das Lichtmikroskop nach Anspruch 14 sowie das Verfahren nach Anspruch 15 gelöst. Vorteilhafte Weiterbildungen der Sensorschaltung sind Gegenstand der Unteransprüche 2 bis 11. Weitere vorteilhafte Ausführungsformen der Erfindung werden im Folgenden beschrieben.

**Beschreibung der Erfindung**

Ein erster Aspekt der Erfindung betrifft eine Sensorschaltung für eine eine Sicherheitsfunktion ausführende Vorrichtung.

Die Sensorschaltung umfasst mindestens zwei Sensoren, wobei jeder der Sensoren dazu ausgebildet ist, eine jeweilige Messgröße zu erfassen und ein Messsignal mit einem von der jeweiligen Messgröße monoton abhängigen Messwert zu erzeugen.

"Monoton abhängig" bedeutet dabei, dass das Messsignal bei steigender Messgröße gleichbleibt oder ansteigt (monoton steigend) oder dass das Messignal bei sinkender Messgröße gleichbleibt oder absinkt (monoton sinkend). Insbesondere ist der Messwert von der jeweiligen Messgröße streng monoton abhängig. Das bedeutet, dass das Messsignal bei steigender Messgröße stets ansteigt und bei sinkender Messgröße stets absinkt. Die Sensoren können die gleiche Messgröße oder verschiedene Messgrößen erfassen, um beispielsweise die Redundanz der Messung zu erhöhen. Insbesondere geben die Sensoren ein analoges Messsignal aus.

Weiterhin weist die Sensorschaltung mindestens zwei Vergleichsschaltungen auf, wobei jede der Vergleichsschaltungen einem der Sensoren zugeordnet ist, und wobei jede der Vergleichsschaltungen einen Messeingang zum Empfangen des Messsignals des jeweiligen zugeordneten Sensors, einen Referenzeingang zum Empfangen eines Referenzsignals zum Festlegen eines Auslöseschwellwerts der Vergleichsschaltung und einen Vergleichsschaltungsausgang aufweist.

Der Vergleichsschaltungsausgang kann einen ersten logischen Zustand und einen zweiten logischen Zustand annehmen, wobei die Zustände z.B. durch die Parameter L=0 und L=1 dargestellt werden können. Der Vergleichsschaltungsausgang ist dazu ausgebildet, ein analoges oder digitales Vergleichsschaltungsausgangssignal mit einem einen der logischen Zustände repräsentierenden Vergleichsschaltungsausgangswert zu erzeugen. Der Auslöseschwellwert kann vorgegeben oder vorgebbar, d.h. veränderbar, sein, und beeinflusst den am Messeingang empfangenen Messwert, bei dem die jeweilige Vergleichsschaltung in einen anderen logischen Zustand schaltet.

Die Vergleichsschaltungen sind insbesondere dazu ausgebildet, einen Signalpegel des jeweiligen empfangenen Messsignals mit einem Signalpegel des jeweiligen empfangenen Referenzsignals zu vergleichen und auf Grund des Vergleichs den logischen Zustand des Vergleichsschaltungsausgangs und somit das erzeugte Vergleichsschaltungsausgangssignal zu bestimmen. Beispielsweise könnte eine erfindungsgemäße Vergleichsschaltung vom Zustand L=0 in den Zustand L=1 wechseln, wenn das Messsignal einen höheren Signalpegel aufweist als das Referenzsignal.

Die Vergleichsschaltungen können, insbesondere bei einer analogen Implementation der Sicherheitsschaltung, als Komparatoren ausgebildet sein. Solche Komparatoren können z.B. durch Messverstärker mit zwei Eingängen und einem Komparatorausgang realisiert sein, wobei der am Komparatorausgang ausgegebene Komparatorausgangswert einen Vergleich der an den beiden Eingängen anliegenden Eingangssignalpegel repräsentiert. Typischerweise ist einer der Eingänge invertierend und der andere Eingang nicht-invertierend.

Alternativ kann die Vergleichsschaltung z.B. auch durch ein Subtraktionsglied bzw. einen Subtrahierer gebildet sein, insbesondere bei einer digitalen Implementierung der erfindungsgemäßen Sensorschaltung. Solche Subtrahierer haben ebenfalls zwei Eingänge und einen Ausgang und bilden die Differenz der beiden Eingangssignale. Abhängig davon, ob die berechnete Differenz größer oder kleiner als Null ist, wird dann der Ausgangspegel bzw. Ausgangswert des Subtrahierers bestimmt. Beispielsweise kann ein digitaler Subtrahierer einen Ausgangswert von 0 ausgeben, wenn die Differenz der Eingangswerte kleiner als Null ist und einen Augangswert von 1 ausgeben, wenn die Differenz der Eingangswerte größer als Null ist.

Die Sensorschaltung umfasst außerdem eine Verknüpfungseinheit, die dazu ausgebildet ist, die logischen Zustände der Vergleichsschaltungsausgänge der mindestens zwei Vergleichsschaltungen mittels einer logischen UND-Operation zu einem Schaltungsausgangssignal der Sensorschaltung zu verknüpfen. Das Schaltungsausgangssignal repräsentiert insbesondere wiederum zwei alternative logische Zustände, die eine UND-Verknüpfung der logischen Zustände der Vergleichsschaltungsausgänge repräsentieren.

Die Verknüpfungseinheit vergleicht somit die Vergleichsschaltungsausgangssignale zweier Vergleichsschaltungen und gibt ein Schaltungsausgangssignal aus, das den logischen Zustand L=1 repräsentiert, wenn die Vergleichsschaltungsausgangssignale beider Vergleichsschaltungen den logischen Zustand L=1 repräsentieren.

Erfindungsgemäß ist die Sensorschaltung dazu ausgebildet, den Vergleichsschaltungsausgangswert mindestens einer ersten der Vergleichsschaltungen zu skalieren und auf den Messeingang oder den Referenzeingang mindestens einer zweiten der Vergleichsschaltungen rückzukoppeln, so dass beim Übergang des Vergleichsschaltungsausgangs der ersten Vergleichsschaltung zwischen den logischen Zuständen (d.h. insbesondere beim Übergang vom Zustand L=0 in den Zustand L=1 und/oder beim Übergang vom Zustand L=1 in den Zustand L=0) die Differenz zwischen dem Messsignal und dem Referenzsignal der zweiten Vergleichsschaltung verringert wird oder sich das Vorzeichen der Differenz zwischen dem Messsignal und dem Referenzsignal der zweiten Vergleichsschaltung umkehrt.

Auf diese Weise wird das Schaltverhalten der mindestens zwei Sensoren zeitlich koordiniert, so dass kurzzeitige Fehlerzustände des Systems vermieden werden. Dadurch können in vielen Fällen unnötige Notabschaltungen oder Übergänge in einen sicheren Zustand vermieden werden, was die Ausfallsicherheit der Sicherheitsvorrichtung verbessert.

Die zeitliche Koordination erfolgt dadurch, dass bei einem durch die Veränderung der Messgröße bewirkten Schalten eines Sensorteilsystems (erster Sensor und Vergleichsschaltung) in einen anderen logischen Zustand die Sensitivität des anderen Sensorteilsystems (zweiter Sensor und Vergleichsschaltung) gezielt erhöht wird. Durch die Skalierung des rückgekoppelten Signals wird das zweite Sensorteilsystem nicht einfach automatisch mitaktiviert, sondern bleibt zu einem großen Teil abhängig von der erfassten Messgröße. Dadurch bleibt die Unabhängigkeit der Sensorkanäle trotz der zeitlichen Koordinierung erhalten und wirkliche Fehlerzustände werden immer noch als solche erfasst.

Wenn der von dem zweiten Sensor erfasste Messwert beim Auslösen der ersten Vergleichsschaltung bereits knapp unterhalb des Auslöseschwellwerts liegt, kann es passieren, dass sich durch die Rückkopplung des skalierten Ausgangssignals der ersten Vergleichsschaltung das Vorzeichen der Differenz zwischen Messwert und Referenzwert der zweiten Vergleichsschaltung umkehrt. In diesem Fall wechselt auch die zweite Vergleichsschaltung sofort in den anderen logischen Zustand. Andernfalls wird lediglich die Differenz zwischen Messwert und Referenzwert verringert, so dass die zweite Vergleichsschaltung bei einer weiteren Veränderung der Messgröße schneller auslöst als ohne die Rückkopplung.

Das Skalieren des Vergleichsschaltungsausgangswertes erfolgt insbesondere durch einen Treiber der Sensorschaltung mit einem Verstärkungsfaktor von ungleich eins, der die Funktion eines Skalierers übernimmt. Dabei ist der Treiber mit dem Messeingang oder dem Referenzeingang der zweiten Vergleichsschaltung verbunden, um den skalierten Vergleichsschaltungsausgangswert auf diesen rückzukoppeln.

Gemäß einer Ausführungsform ist die Sensorschaltung dazu ausgebildet, den Vergleichsschaltungsausgangswert der zweiten Vergleichsschaltung zu skalieren und auf den Messeingang oder den Referenzeingang der ersten Vergleichsschaltung rückzukoppeln, so dass beim Übergang des Vergleichsschaltungsausgangs der zweiten Vergleichsschaltung zwischen den logischen Zuständen die Differenz zwischen dem Messsignal und dem Referenzsignal der ersten Vergleichsschaltung verringert wird oder sich das Vorzeichen der Differenz zwischen dem Messwertwertsignal und dem Referenzsignal der ersten Vergleichsschaltung umkehrt. Mit anderen Worten: Zwischen den Vergleichsschaltungen ist gemäß dieser Ausführungsform eine kreuzweise Rückkopplung als Mitkopplung implementiert.

Gemäß einer Ausführungsform ist die Sensorschaltung, insbesondere der Treiber bzw. Skalierer, dazu ausgebildet, den Vergleichsschaltungsausgangswert der ersten Vergleichsschaltung (oder der zweiten Vergleichsschaltung) mit einem Faktor von < 0,5, insbesondere von < 0,2, weiter insbesondere von < 0,1 zu skalieren. Je geringer der Skalierungsfaktor ist, desto mehr bleibt die jeweils andere Vergleichsschaltung abhängig von der erfassten Messgröße des ihm zugeordneten Sensors, so dass die Unabhängigkeit der Sensorkanäle weiter verbessert ist. Im konkreten Fall könnte der Wert des Skalierungsfaktors angepasst werden, um ein Optimum zwischen der zeitlichen Koordination und der Unabhängigkeit der Sensoren zu erzielen.

Gemäß einer weiteren Ausführungsform ist die Sensorschaltung dazu ausgebildet, das Referenzsignal einer der Vergleichsschaltungen, insbesondere der zweiten Vergleichsschaltung, durch eine gewichtete Summe aus dem Auslöseschwellwert dieser Vergleichsschaltung, insbesondere der zweiten Vergleichsschaltung, und dem mit einem Gewichtungsfaktor gewichteten Vergleichsschaltungsausgangswert einer anderen der Vergleichsschaltungen, insbesondere der ersten Vergleichsschaltung, und optional dem mit einem Gewichtungsfaktor gewichteten Vergleichsschaltungsausgangswert mindestens einer weiteren der Vergleichsschaltungen zu bilden. Das heißt insbesondere, das Referenzsignal $r_j$ der Vergleichsschaltung mit dem Index $j$ wird durch die Summe $r_j = a_j + g_{ij}Y_i$ bestimmt, wobei $a_j$ den Auslöseschwellwert der Vergleichsschaltung $j$, $g_{ij}$ den Gewichtungsfaktor und $Y_i$ das Vergleichsschaltungsausgangssignal der Vergleichsschaltung mit dem Index $i$ bezeichnet.

Alternativ oder zusätzlich dazu kann die Sensorschaltung dazu ausgebildet sein, das Messsignal einer der Vergleichsschaltungen, insbesondere der zweiten Vergleichsschaltung, durch eine gewichtete Summe aus dem Messsignal des dieser Vergleichsschaltung, insbesondere der zweiten Vergleichsschaltung, zugeordneten Sensors und dem mit einem Gewichtungsfaktor gewichteten Vergleichsschaltungsausgangswert einer anderen der Vergleichsschaltungen, insbesondere der ersten Vergleichsschaltung, und optional dem mit einem Gewichtungsfaktor gewichteten Vergleichsschaltungsausgangswert mindestens einer weiteren der Vergleichsschaltungen zu bilden. Das heißt insbesondere, das Messsignal $m_j$ der Vergleichsschaltung mit dem Index $j$ wird durch die Summe $m_j = a_j + g'_{ij} Y_i$ bestimmt,

wobei $a_j$ den Messwert des der Vergleichsschaltung $j$ zugeordneten Sensors, $g'_{ij}$ den Gewichtungsfaktor und $Y_i$ das Vergleichsschaltungsausgangssignal der Vergleichsschaltung mit dem Index i bezeichnet.

Die Gewichtungsfaktoren können durch eine Matrix $g_{ij}$ (im Falle der Rückkopplung auf den Referenzeingang der jeweiligen Vergleichsschaltung) bzw. $g'_{ij}$ (im Falle der Rückkopplung auf den Messeingang der jeweiligen Vergleichsschaltung) ausgedrückt werden. Dabei bezeichnet der Index i diejenige Vergleichsschaltung, deren Vergleichsschaltungsausgangswert skaliert und rückgekoppelt wird und der Index $j$ bezeichnet die Vergleichsschaltung, deren Referenzsignal oder Messsignal mittels der gewichteten Summe gebildet wird. Das Bilden der gewichteten Summen kann insbesondere durch Summierer der Sensorschaltung erfolgen. Insbesondere weist die Hauptdiagonale der Matrix $g_{ij}$ ausschließlich Werte von Null auf, d.h. die Vergleichsschaltungsausgänge werden nicht auf sich selbst rückgekoppelt.

Gemäß einer weiteren Ausführungsform ist der bei der Bildung des Referenzsignals aus der gewichteten Summe verwendete Gewichtungsfaktor kleiner oder gleich Null oder der bei der Bildung des Messsignals durch die gewichtete Summe verwendete Gewichtungsfaktor größer oder gleich Null, wenn der Vergleichsschaltungsausgangswert der ersten Vergleichsschaltung im ersten logischen Zustand (L=0) kleiner ist als im zweiten logischen Zustand (L=1) und der Messwert des der zweiten Vergleichsschaltung zugeordneten Sensors in Abhängigkeit der Messgröße monoton steigt oder wenn der Vergleichsschaltungsausgangswert der ersten Vergleichsschaltung im ersten logischen Zustand (L=0) größer ist als im zweiten logischen Zustand (L=1) und der Messwert des der zweiten Vergleichsschaltung zugeordneten Sensors in Abhängigkeit der Messgröße monoton fällt.

Gemäß einer weiteren Ausführungsform ist der bei der Bildung des Referenzsignals aus der gewichteten Summe verwendete Gewichtungsfaktor größer oder gleich Null oder der bei der Bildung des Messsignals durch die gewichtete Summe verwendete Gewichtungsfaktor kleiner oder gleich Null, wenn der Vergleichsschaltungsausgangswert der ersten Vergleichsschaltung im ersten logischen Zustand (L=0) größer ist als im zweiten logischen Zustand (L=1) und der Messwert des der zweiten Vergleichsschaltung zugeordneten Sensors in Abhängigkeit der Messgröße monoton steigt oder wenn der Vergleichsschaltungsausgangswert der ersten Vergleichsschaltung im ersten logischen Zustand (L=0) kleiner ist als im zweiten logischen Zustand (L=1) und der Messwert des der zweiten Vergleichsschaltung zugeordneten Sensors in Abhängigkeit der Messgröße monoton fällt.

Diese Zusammenhänge können insbesondere auch auf die folgende Weise zusammengefasst werden, wobei $g_{ij}$ die Matrix der Gewichtungsfaktoren bei der Rückkopplung des Vergleichsschaltungsausgangssignals der i -ten Vergleichsschaltung auf den Referenzeingang der $j$ -ten Vergleichsschaltung, $g'_{ij}$ die Matrix der Gewichtungsfaktoren bei der Rückkopplung des Vergleichsschaltungsausgangssignals der i -ten Vergleichsschaltung auf den Messeingang der $j$ -ten Vergleichsschaltung, $Y(L=0)$ den Vergleichsschaltungsausgangswert im ersten logischen Zustand, $Y(L=1)$ den Vergleichsschaltungsausgangswert im zweiten logischen Zustand und $y(x)$ die Funktion des Messwerts des jeweiligen Sensors von der Messgröße x bezeichnet:

$$\begin{cases} g_{ij} \leq 0, g'_{ij} \geq 0 & \text{wenn } Y(L=0) < Y(L=1) \text{ und } y(x) \text{ monoton steigend} \\ g_{ij} \leq 0, g'_{ij} \geq 0 & \text{wenn } Y(L=0) > Y(L=1) \text{ und } y(x) \text{ monoton fallend} \\ g_{ij} \geq 0, g'_{ij} \leq 0 & \text{wenn } Y(L=0) > Y(L=1) \text{ und } y(x) \text{ monoton steigend} \\ g_{ij} \geq 0, g'_{ij} \leq 0 & \text{wenn } Y(L=0) < Y(L=1) \text{ und } y(x) \text{ monoton fallend} \end{cases}$$

Gemäß einer weiteren Ausführungsform sind der erste logische Zustand und der zweite logische Zustand durch elektrische Signalpegel, insbesondere durch TTL-, LVTTL-, CMOS-, ECL-, PECL-, LVECL-, LVPECL- oder LVDS-Signalpegel, repräsentiert.

Gemäß einer weiteren Ausführungsform sind logisch gleiche logische Zustände der Vergleichsschaltungsausgänge verschiedener der Vergleichsschaltungen durch unterschiedliche, insbesondere komplementäre, elektrische Signalpegel repräsentiert.

Gemäß einer weiteren Ausführungsform sind der erste logische Zustand und der zweite logische Zustand durch optische Signalzustände, insbesondere durch Intensitäts-, Wellenlängen- oder Polarisationszustände repräsentiert.

Gemäß einer weiteren Ausführungsform sind logisch gleiche logische Zustände der Vergleichsschaltungsausgänge verschiedener der Vergleichsschaltungen durch unterschiedliche, insbesondere komplementäre, optische Signalzustände repräsentiert.

Gemäß einer weiteren Ausführungsform sind die Messwerte durch analoge Spannungs- oder Stromwerte repräsentiert.

Gemäß einer weiteren Ausführungsform sind die Messwerte durch Zahlen in einer binären Darstellung repräsentiert.

Gemäß einer weiteren Ausführungsform sind die Messgrößen unabhängig voneinander ausgewählt aus der Gruppe: mechanischer Weg, mechanische Kraft, Druck, Lichtintensität, Polarisation, Temperatur, Lautstärke, Kapazität, Induktivität, magnetischer Fluss, elektrische Spannung, elektrischer Strom oder elektrische Feldstärke. Mit anderen Worten: Jeder der mindestens zwei Sensoren kann gemäß dieser Ausführungsform unabhängig von dem anderen Sensor oder den anderen Sensoren eine der genannten Messgrößen erfassen. Für die mindestens zwei Sensoren sind nach dieser Ausführungsform also beliebige Kombinationen der genannten Messgrößen möglich. In dieser Ausführungsform ist der Vermeidung systematischer Ausfälle durch Verwendung diversitärer Bauteile und Messprinzipien in besonderer Weise Rechnung getragen.

Gemäß einer weiteren Ausführungsform sind die Sensoren unabhängig voneinander gewählt aus der Gruppe: Hallsensoren, Fotodioden, Fototransistoren, Fotowiderstände, Thermoelemente, kapazitive oder induktive Abstandssensoren, Dehnungsmessstreifen, Mikrofone, einstellbare Widerstände, einstellbare Kondensatoren, einstellbare Induktivitäten. D.h., jeder der mindestens zwei Sensoren kann unabhängig von allen anderen Sensoren einem der genannten Typen entsprechen.

Gemäß einer weiteren Ausführungsform sind die Sensoren dazu ausgebildet, unterschiedliche Messgrößen zu erfassen.

Gemäß einer weiteren Ausführungsform sind die Sensoren dazu ausgebildet, die gleiche Messgröße zu erfassen, beruhen aber auf unterschiedlichen Messprinzipien oder gehören unterschiedlichen Sensortypen an.

Beide letztgenannten Ausführungsformen verbessern die Redundanz der Sensorschaltung.

Gemäß einer weiteren Ausführungsform weist die Sensorschaltung eine Fehlererkennungseinheit auf, wobei die Fehlererkennungseinheit dazu ausgebildet ist, die logischen Zustände der Vergleichsschaltungsausgänge mittels einer logischen Exklusiv-ODER-Operation zu einem Fehlersignal der Sensorschaltung zu verknüpfen. Durch die Fehlererkennungseinheit können vorteilhafterweise Fehlerzustände erkannt werden, in denen die Vergleichsschaltungsausgangssignale unterschiedliche logische Zustände repräsentieren.

Ein zweiter Aspekt der Erfindung bezieht sich auf eine Vorrichtung zum Ausführen einer Sicherheitsfunktion umfassend eine Sensorschaltung nach dem ersten Aspekt der Erfindung.

Gemäß einer Ausführungsform ist die Vorrichtung eine Maschine mit einem Abschirmungselement zum Schutz vor einer Berührung elektrisch, pneumatisch oder hydraulisch angetriebener Elemente, wobei die Sensorschaltung dazu ausgebildet ist, einen Zustand des Abschirmungselements zu überwachen. Insbesondere ist das Abschirmungselement beweglich ausgebildet, wobei das Abschirmungselement mindestens einen ersten Zustand, in dem die angetriebenen Elemente von außen zugänglich sind und einen zweiten Zustand aufweist, in dem die angetriebenen Elemente zum Schutz vor einer Berührung durch das Abschirmungselement abgedeckt sind. Das Abschirmungselement kann z.B. eine abnehmbare, schwenkbare oder verschiebbare Abdeckung, eine verschließbare Tür, Klappe oder Luke in einem Gehäuse der Maschine oder Ähnliches sein. Als Sensoren zur Überwachung des Zustands kommen z.B. mit Permanent- oder Elektromagneten kombinierte Magnetsensoren, z.B. Hall-Sensoren, in Frage. Alternativ können z.B. optische Sensoren wir Fotodioden, -transistoren oder -widerstände in Kombination mit einer Lichtquelle (z.B. einer LED) verwendet werden. Die Lichtquelle kann dabei z.B. so zu dem optischen Sensor angeordnet sein, dass in einem ersten Zustand des Abschirmungselements Licht von der Lichtquelle auf den Sensor fällt, während in einem zweiten Zustand kein oder weniger Licht den Sensor erreicht. Alternativ können auch mechanische Wegaufnehmer wie z.B. lineare Potentiometer eingesetzt werden.

Als Sensorprinzip kommt weiterhin die Kapazitätsänderung zueinander verschobener leitfähiger Flächen in Frage. Bei solchen kapazitiven Sensoren kann z.B. aus einer rohrförmigen Elektrode und einer stabförmigen Elektrode ein Kondensator gebildet sein. Eine der Elektroden kann mit dem Abschirmungselement und die andere Elektrode z.B. mit dem Gehäuse der Vorrichtung verbunden sein. Wenn die stabförmige Elektrode beim relativen Verlagern des Abschirmungselements zum Gehäuse in die rohrförmige Elektrode eintaucht, kann so der Zustand des Abschirmungselements sensorisch erfasst werden.

Gemäß einer weiteren Ausführungsform ist die Vorrichtung eine Laservorrichtung, wobei die Laservorrichtung einen Laser der Laserklasse 3, 3B, 3R oder 4 umfasst.

Gemäß einer weiteren Ausführungsform weist die Vorrichtung weiterhin ein Abschirmungselement zum Schutz vor einem Austritt von Laserstrahlung aus der Laservorrichtung auf, wobei die Sensorschaltung dazu ausgebildet ist, einen Zustand des Abschirmungselements zu überwachen. Insbesondere ist das Abschirmungselement beweglich ausgebildet, wobei das Abschirmungselement mindestens einen ersten Zustand, in dem Laserstrahlung austreten kann und einen zweiten Zustand aufweist, in dem das Abschirmungselement den Austritt der Laserstrahlung verhindert. Das Abschirmungselement kann auch hier z.B. eine abnehmbare, schwenkbare oder verschiebbare Abdeckung, eine verschließbare Tür, Klappe oder Luke in einem Gehäuse der Laservorrichtung oder Ähnliches sein. Als Sensoren zur Überwachung des Zustands kommen auch hier z.B. mit Permanent- oder Elektromagneten kombinierte Magnetsensoren, z.B. Hall-Sensoren, optische Sensoren, mechanische Wegaufnehmer und kapazitive Sensoren in Frage (siehe oben).

Gemäß einer weiteren Ausführungsform weist die Vorrichtung ein in verschiedene Einstellpositionen bewegliches optisches Element auf, wobei die Sensorschaltung dazu ausgebildet ist, einen Zustand des optischen Elements zu überwachen. Dabei ist der Zustand des optischen Elements insbesondere eine Anordnung des optischen Elements in einem Strahlengang der Laservorrichtung.

Gemäß einer Ausführungsform weist die Laservorrichtung weiterhin ein Okular zum Betrachten von mittels der Laserstrahlung beleuchteten Objekten auf, wobei die Sensorschaltung dazu ausgebildet ist, Zustände des beweglichen optischen Elements zu erkennen, in denen Reflexe der Laserstrahlung in das Okular gelangen können. Bei dem beweglichen optischen Element kann es sich z.B. um einen verschiebbaren oder drehbaren Spiegel oder eine bewegliche Filteranordnung wie ein Filterrad zum wahlweisen Anordnen verschiedener optischer Filter in einem Strahlengang handeln. Als Sensoren kommen hier z.B. Lichtsensoren wie etwa Photodioden oder magnetische Sensoren wie Hallsensoren in Frage, die beispielsweise an geeigneter Position an dem beweglichen optischen Element angeordnet sein können.

Ein dritter Aspekt betrifft ein Lichtmikroskop umfassend eine Sensorschaltung nach dem ersten Aspekt der Erfindung und/oder eine Vorrichtung nach dem zweiten Aspekt der Erfindung, insbesondere umfassend die oben beschriebene Laservorrichtung.

Das Lichtmikroskop weist insbesondere mindestens einen gepulsten oder kontinuierlichen Laser zum Beleuchten einer Probe mit Laserlicht auf. Mit dem Laserlicht können z.B. Emitter, wie Fluorophore, in der Probe zur Emission von Licht (insbesondere Fluoreszenzlicht) angeregt werden. Weiterhin kann die Probe mit weiterem Laserlicht zum Ausschalten oder Depletieren der Emission der Emitter in bestimmten Probenbereichen beleuchtet werden, wie es beispielsweise aus der sogenannten STED- und RESOLFT-Mikroskopie bekannt ist.

Das Lichtmikroskop weist weiterhin ein Objektiv zum Bündeln des Laserlichts auf. Dabei kann insbesondere ein Fokus des Laserlichts in der Probe erzeugt werden. Dieser Fokus kann mittels eines Scanners über, bzw. durch die Probe bewegt werden. Das von den Emittern emittierte Licht kann (z.B. durch dasselbe Objektiv) zu einem Detektor gelangen, insbesondere über eine konfokale Lochblende, wie es in der konfokalen Laserscanning-Mikroskopie üblich ist. Alternativ zum Scannen des Laserlichts über die Probe ist auch eine Weitfeldbeleuchtung der Probe mit dem Laserlicht möglich. In diesem Fall wird das emittierte Licht häufig von einer Kamera detektiert. Das Lichtmikroskop kann weiterhin optische Filter, Strahlformungsmittel wie Phasenmodulatoren und dergleichen aufweisen.

Ein vierter Aspekt der Erfindung bezieht sich auf ein Verfahren zum Verarbeiten von Messwerten von Sensoren für eine eine Sicherheitsfunktion ausführende Vorrichtung, insbesondere mittels der Sensorschaltung nach dem ersten Aspekt der Erfindung. Das Verfahren umfasst die folgenden Schritte, die nicht notwendigerweise nacheinander, sondern auch ggf. in veränderter Reihenfolge, gleichzeitig oder zeitlich überlappend durchgeführt werden können:

- Erfassen einer jeweiligen Messgröße und Erzeugen eines jeweiligen Messsignals mit einem von der jeweiligen Messgröße monoton abhängigen Messwert mittels mindestens zwei Sensoren,

- Empfangen der Messsignale durch jeweilige Messwerteingänge von mindestens zwei Vergleichsschaltungen, wobei jede der Vergleichsschaltungen einem der Sensoren zugeordnet ist,

- Empfangen von Referenzsignalen zum Festlegen eines Auslöseschwellwerts durch jeweilige Referenzwerteingänge der Vergleichsschaltungen,

- Ausgeben von Vergleichsschaltungsausgangssignalen durch jeweilige Vergleichsschaltungsausgänge der Vergleichsschaltungen, wobei die jeweiligen Vergleichsschaltungsausgänge einen ersten logischen Zustand und einen zweiten logischen Zustand annehmen können, und wobei die Vergleichsschaltungsausgangssignale jeweils einen Vergleichsschaltungsausgangswert aufweisen, der einen der logischen Zustände repräsentiert,

- Verknüpfen der logischen Zustände zu einem Schaltungsausgangssignal mittels einer logischen UND-Operation und

- Skalieren des Vergleichsschaltungsausgangswerts mindestens einer ersten der Vergleichsschaltungen und Rückkoppeln des skalierten Vergleichsschaltungsausgangswertes auf den Messeingang oder den Referenzeingang mindestens einer zweiten der Vergleichsschaltungen, so dass beim Übergang des Vergleichsschaltungsausgangs der ersten Vergleichsschaltung zwischen dem ersten logischen Zustand und dem zweiten logischen Zustand die Differenz zwischen dem Messsignal und dem Referenzsignal der zweiten Vergleichsschaltung verringert wird oder sich das Vorzeichen der Differenz zwischen dem Messwertsignal und dem Referenzsignal der zweiten Vergleichsschaltung umkehrt.

Vorteilhafte Weiterbildungen der Erfindung ergeben sich aus den Patentansprüchen, der Beschreibung und den Zeichnungen und den zugehörigen Erläuterungen zu den Zeichnungen. Die beschriebenen Vorteile von Merkmalen und / oder Merkmalskombinationen der Erfindung sind lediglich beispielhaft und können alternativ oder kumulativ zur Wirkung kommen. Hinsichtlich des Offenbarungsgehalts (aber nicht des Schutzbereichs) der ursprünglichen Anmeldungsunterlagen und des Patents gilt Folgendes: Weitere Merkmale sind den Zeichnungen - insbesondere den dargestellten relativen Anordnungen und Wirkverbindungen - zu entnehmen.

Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen, was aber nicht für die unabhängigen Patentansprüche des erteilten Patents gilt.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

**Kurzbeschreibung der Figuren**

**Fig. 1**    zeigt ein Blockdiagramm einer erfindungsgemäßen Sensorschaltung.

**Fig. 2**    zeigt eine Sensoreinheit mit einer alternativen Beschaltung der Vergleichsschaltungen.

**Fig. 3**    zeigt eine Sensoreinheit mit einer weiteren alternativen Beschaltung der Vergleichsschaltungen.

**Fig. 4**    zeigt eine Sensoreinheit mit einer weiteren alternativen Beschaltung der Vergleichsschaltungen.

**Fig. 5**    zeigt eine Sensoreinheit in digitaler Ausführung.

**Fig. 6**    zeigt den Schaltplan einer erfindungsgemäßen analogen Sensorschaltung.

**Fig. 7**    zeigt die Simulation einer erfindungsgemäßen Sensorschaltung.

**Fig. 8**    zeigt eine Vorrichtung mit einer erfindungsgemäßen Sensorschaltung.

**Beschreibung der Figuren**

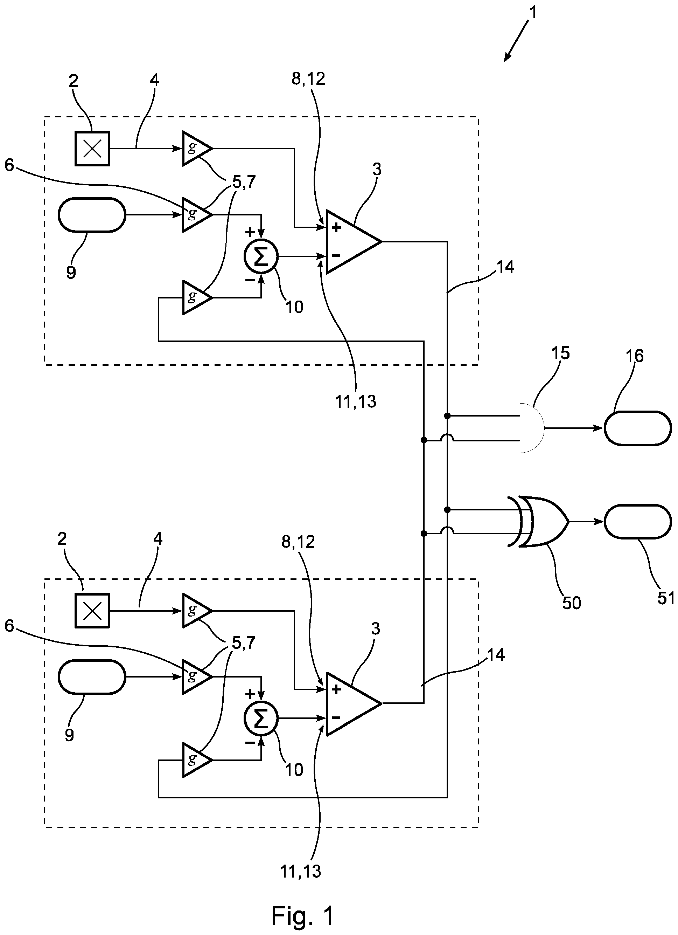

In **Fig. 1** ist eine erfindungsgemäße Sensorschaltung 1 als Blockdiagramm dargestellt. Die gezeigte Ausführungsform umfasst zwei Sensoren 2 mit je einer zugeordneten Vergleichsschaltung 3. Die Vergleichsschaltungen 3 sind gemäß diesem Ausführungsbeispiel als Komparatoren ausgebildet. Die Messwerte 4 der Sensoren 2 werden über Treiber 5, die bei einem Verstärkungsfaktor 6 von ungleich eins auch die Funktion eines Skalierers 7 übernehmen, den Messwerteingängen 8 der Vergleichsschaltungen 3 zugeführt.

In der gezeigten Ausführungsform ist der Messwert 4 der Sensoren 2 proportional zum Wert der jeweils gemessenen Messgröße, d. h. der Messwert y(x) 4 steigt mit der Messgröße x monoton an. Die Schaltpunkte der Vergleichsschaltungen 3 sind durch für jede Vergleichsschaltung 3 individuell einstellbare oder voreingestellte Auslöseschwellwerte 9 vorgegeben, die über je einen Summierer 10 den Referenzwerteingängen 11 der Vergleichsschaltungen 3 zugeführt werden.

Die Messeingänge 8 der Vergleichsschaltungen 3 sind nichtinvertierende Eingänge 12, wohingegen die Referenzeingänge 11 invertierende Eingänge 13 sind, so dass die Vergleichsschaltungsausgangswerte 14 der Vergleichsschaltungen 3 logische "1"-Werte annehmen, wenn der am Messeingang 8 der jeweiligen Vergleichsschaltung 3 anliegende Pegel größer ist als der am Referenzeingang 11 der jeweiligen Vergleichsschaltung 3 anliegende Pegel, und einen logischen "0"-Wert, wenn der am Messeingang 8 anliegende Pegel kleiner ist als der am Referenzeingang 11 anliegende Pegel.

Der Vergleichsschaltungsausgangswert 14 jeder Vergleichsschaltung 3 wird mit einem Skalierer 7 individuell skaliert und über die Summierer 10 auf die Referenzwerteingänge 11 der jeweils anderen Vergleichsschaltung 3 rückgekoppelt. Auf diese Weise führt das Umschalten einer Vergleichsschaltung 3 zwischen den logischen Zuständen zu einer Veränderung der Sensitivität der anderen Vergleichsschaltung 3. Die Umschaltvorgänge der beiden redundanten Sensorkanäle werden somit zeitlich synchronisiert und transiente Fehlerzustände, die auf einer Verzögerung des Schaltverhaltens eines Sensorkanals gegenüber dem anderen Sensorkanal beruhen, treten mit einer geringeren Häufigkeit bzw. für kürzere Zeit auf.

Die logischen Zustände der Vergleichsschaltungsausgänge 14 werden in der Verknüpfungseinheit 15 mit einer logischen UND-Operation verknüpft und die Verknüpfungseinheit 15 gibt einen Sensorausgangswert 16 aus, der den durch die UND-Operation erhaltenen logischen Zustand repräsentiert.

Optional kann die Sensorschaltung weiterhin eine Fehlererkennungseinheit 50 aufweisen, welche die Vergleichsschaltungsausgangssignale der Vergleichsschaltungsausgänge 14 durch eine Exklusiv-ODER-Operation verknüpft und ein entsprechendes Fehlersignal 51 ausgibt, das den logischen Zustand L=1 repräsentiert, wenn die beiden Vergleichsschaltungsausgangssignale unterschiedliche logische Zustände repräsentieren. Auf diese Weise können Fehlerzustände erkannt werden.

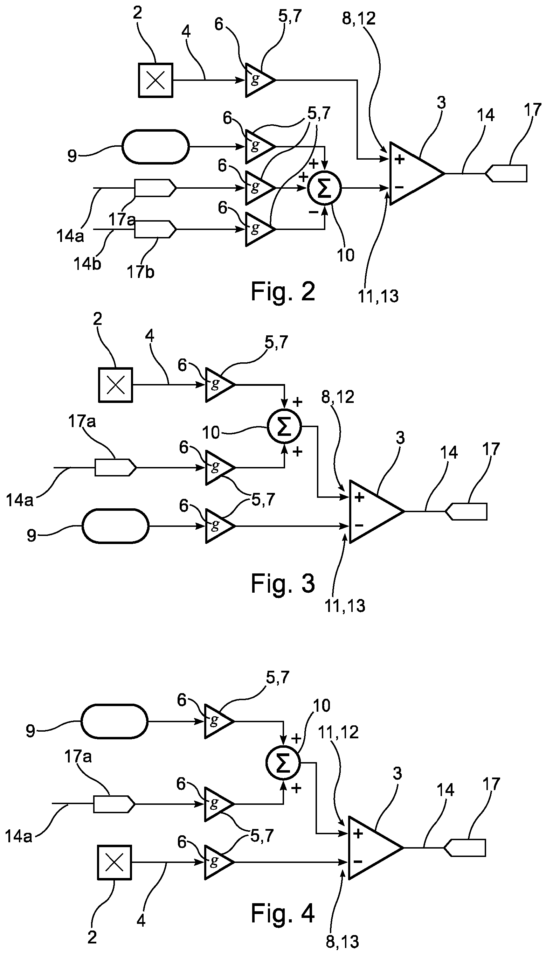

Die **Figuren 2 bis 4** zeigen jeweils einen Teil einer Sensorschaltung 1 gemäß weiterer Ausführungsformen der vorliegenden Erfindung bestehend aus einem Sensor 2, einer Vergleichsschaltung 3 (die hier ebenfalls als Komparator ausgebildet ist), einem Summierer 10 und mehreren Treibern 5, die die Funktion eines Skalierers 7 ausüben.

Die in **Fig. 2** dargestellte Ausführungsform unterscheidet sich darin von der in Fig. 1 dargestellten und oben beschriebenen Ausführungsform, dass zwei Vergleichsschaltungsausgänge 14a, 14b von in Fig. 2 nicht gezeigten Vergleichsschaltungen 3 skaliert und über den Summierer 10 auf den invertierenden Referenzeingang 11, 13 rückgekoppelt werden.

Dabei ist einer der Vergleichsschaltungsausgänge 14a mit einem addierenden Eingang (+), der andere Vergleichsschaltungsausgang 14b mit einem subtrahierenden Eingang (-) des Summierers 10 verbunden. Ein weiterer addierender Eingang (+) des Summierers 10 erhält den gegebenenfalls über einen weiteren Treiber/Skalierer 5,7 skalierten Auslöseschwellwert 9. Somit berechnet der Summierer 10 die Summe des skalierten Auslöseschwellwerts und des skalierten ersten Vergleichsschaltungsausgangswertes abzüglich des skalierten zweiten Vergleichsschaltungsausgangswertes.

**Fig. 3** zeigt eine Ausführungsform, bei der das Signal des Vergleichsschaltungsausgangs 14a einer Vergleichsschaltung 3 (nicht gezeigt) auf den Messwerteingang 8 der anderen Vergleichsschaltung 3 rückgekoppelt wird. Dabei werden der Vergleichsschaltungsausgangswert 17a und der Messwert 4 des Sensors 2 mittels jeweiliger Treiber 5, die als Skalierer 7 ausgebildet sind, mit jeweiligen Gewichtungsfaktoren skaliert und mittels des Summierers 10 addiert.

Das addierte Signal wird dann dem Messwerteingang 8 der Vergleichsschaltung 3, welcher als nicht-invertierender Eingang 12 konfiguriert ist, zugeführt. Der mittels eines weiteren Treibers 5 / Skalierers 7 skalierte Auslöseschwellwert 9 wird dem Referenzeingang 11 zugeführt.

Der Vergleichsschaltungsausgang 14 wechselt somit in den logischen Zustand L=1, wenn die Summe zwischen dem Messwert 4 und dem skalierten rückgekoppelten Vergleichsschaltungsausgangswert 17a größer ist als der Auslöseschwellwert 9.

In der **Fig. 4** ist eine Ausführungsform gezeigt, bei der der Auslöseschwellwert 9 und der Vergleichsschaltungsausgangswert 17a des Vergleichsschaltungsausgangs 14a (von der hier nicht gezeigten Vergleichsschaltung 3) über jeweilige Treiber 5 / Skalierer 7 skaliert, mittels des Summierers 10 summiert und dem Referenzeingang 11 der Vergleichsschaltung 3 zugeführt werden, der als nicht-invertierender Eingang 12 ausgeführt ist.

Der mittels des Sensors 2 gemessene Messwert 4 wird über einen weiteren Treiber 5 / Skalierer 7 skaliert und gelangt zum Messwerteingang 8 der Vergleichsschaltung 3, der hier als invertierender Eingang 13 ausgeführt ist. Daher wechselt der Vergleichsschaltungsausgang 14 in den logischen Zustand L=1, wenn die Summe aus dem skalierten Auslöseschwellwert 9 und dem skalierten Vergleichsschaltungsausgangswert 17a den skalierten Messwert 4 überschreitet.

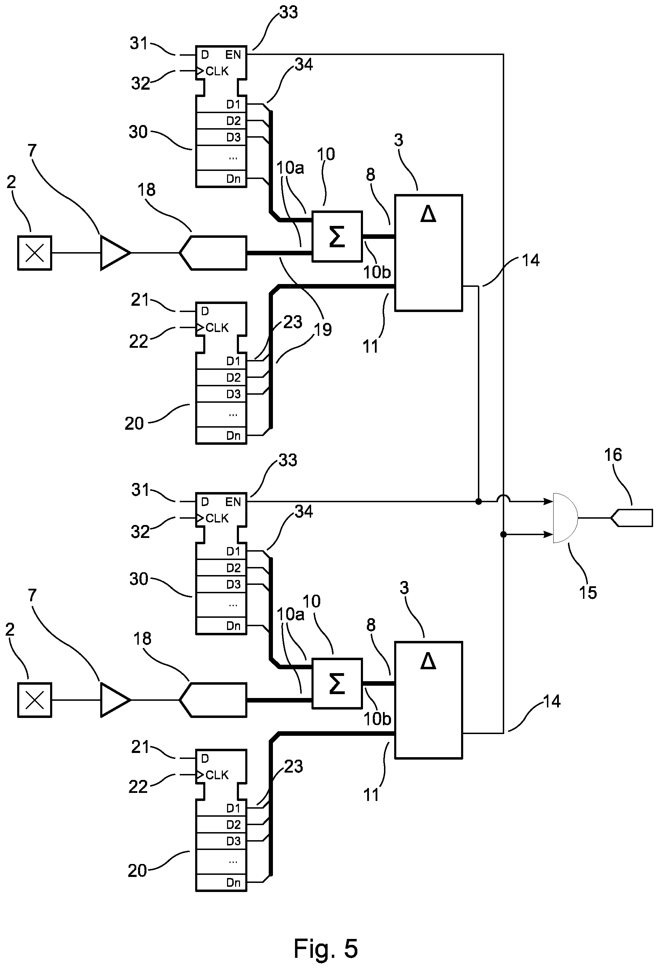

**Fig. 5** zeigt ein digitales Ausführungsbeispiel der erfindungsgemäßen Sensorschaltung 1. Die analogen Messsignale der zwei redundanten Sensoren 2 der Sensorschaltung werden durch jeweilige Skalierer 7 skaliert und anschließend von einem jeweiligen Analog-Digital-Wandler 18 digitalisiert.

Die Analog-Digital-Wandler 18 können auch in den jeweiligen Sensoren 2 integriert sein, so dass die Sensoren 2 bereits ein digitales Ausgangssignal liefern. Weiterhin kann auch die Skalierung sensorintern implementiert sein, so dass gegebenenfalls auf die Skalierer 7 verzichtet werden kann. Insbesondere können auch einfach Sensoren 2 mit bestimmten Messbereichen ausgewählt werden, um die Skalierungsfaktoren festzulegen, ohne dass Skalierer 7 vorgesehen sind.

Die digitalisierten Messsignale werden mittels Datenleitungen 19 über einen jeweiligen Summierer bzw. Addierer 10 zur Addition eines Bias-Werts (siehe unten) einem Messeingang 8 einer Vergleichsschaltung 3 zugeführt, die als Subtrahierer ausgebildet ist.

Referenzeingänge 11 der Vergleichsschaltungen 3 erhalten von Datenausgängen 34 eines jeweiligen Referenzwert-Registers 30 digital (mit den binären Zahlen D1 bis Dn) kodierte Referenzsignale, die den jeweiligen Auslöseschwellwert 9 der Vergleichsschaltungen festlegen.

Die Vergleichsschaltungen 3 berechnen die Differenz zwischen dem jeweiligen Messsignal und dem jeweiligen Referenzsignal und geben an dem Vergleichsschaltungsausgang 14 ein binäres Signal aus, welches insbesondere bei einer Differenz zwischen dem Messsignal und dem Referenzsignal, die kleiner als Null ist, den Wert 0 hat und bei einer Differenz, die größer als Null ist, den Wert 1 hat.

Eine Verknüpfungseinheit 15, welche als digitales UND-Gatter ausgebildet ist, verknüpft die Vergleichsschaltungsausgangssignale der Vergleichsschaltungen 3 mittels einer logischen UND-Operation und gibt ein entsprechendes binäres Schaltungsausgangssignal 16 aus, das den Wert 1 hat, wenn beide Vergleichsschaltungen 3 den Vergleichsschaltungsausgangswert ausgeben, der eine Differenz größer als Null repräsentiert.

Der in dem Referenzwert-Register 20 gespeicherte Auslöseschwellwert kann durch Anlegen eines Datensignals an den Dateneingang 21 und eines Taktsignals an den Takteingang 22 des Referenzwert-Registers 20 geändert werden. Dabei erhalten insbesondere die einzelnen Bits D1 bis Dn des Referenzwert-Registers 20 in bekannter Weise nacheinander in einem von dem Taktsignal vorgegebenen Takt Datensignale, deren Pegel der Wert 0 oder der Wert 1 zugeordnet wird. Dieser Schritt wird insbesondere bereits bei Inbetriebnahme der Sensorschaltung 1 durchgeführt, was beim späteren Betrieb die Datensynchronisation erleichtert.

Um die erfindungsgemäße Rückkopplung umzusetzen, sind die Vergleichsschaltungsausgänge 14 der Vergleichsschaltungen 3 zusätzlich mit einem Enable-Eingang 33 des Bias-Registers 30 verbunden, das dem jeweils anderen Sensor 2 zugeordnet ist.

In dem Bias-Register 30 ist ein Bias-Wert in digital kodierter Form gespeichert. Auf dieselbe Weise wie bei dem Referenzwert-Register 20 kann dieser Bias-Wert durch Anlegen eines Datensignals an einen Dateneingang 31 und Anlegen eines Taktsignals an den Takteingang 32 des Bias-Registers 30 geändert werden.

Wenn an dem Enable-Eingang 33 des jeweiligen Bias-Registers 30 ein Signal anliegt, das den Wert bzw. logischen Zustand 1 repräsentiert, wird der Bias-Wert über die Datenausgänge 34 zu einem Eingang 10a des jeweiligen Summierers 10 geleitet und zu dem digitalisierten Messsignal des jeweiligen Sensors 2 addiert. Der Enable-Eingang 33 steuert also insbesondere nur die Ausgabe des gespeicherten Bias-Werts, aber nicht das Überschreiben des gespeicherten Bias-Werts über den Dateneingang 31.

Durch das Aktivieren des Enable-Eingangs aufgrund der erfindungsgemäßen Rückkopplung wird die Differenz zwischen dem Messeingang 8 und dem Referenzeingang 11 reduziert bzw. das Vorzeichen dieser Differenz umgekehrt. Auf diese Weise kann die die zeitliche Antwort der Sensoren 2 bei gleichzeitiger Aufrechterhaltung ihrer Unabhängigkeit synchronisiert werden.

Selbstverständlich kann der Bias-Wert auch eine negative Zahl sein, was dann zu einem niedrigeren Ausgangswert des Summierers 10 im Vergleich zum Wert des Messsignals des Sensors 2 führt.

Zudem kann alternativ zu der in Fig. 5 dargestellten Ausführungsform auch das Ausgangssignal des Referenzwert-Registers 20 mit dem Ausgangssignal des Bias-Registers 30 über einen Summierer 10 bzw. Addierer verknüpft sein, um eine Anpassung des Referenzsignals per Rückkopplung zu erzielen.

Bei den Datenleitungen 19 der in Fig. 5 gezeigten digitalen Sensorschaltung 1 kann es sich insbesondere um einen Datenbus handeln. Alternativ kann die gesamte Sensorschaltung 1 oder können Teile davon auch auf einem Schaltkreis integriert sein, z.B. auf einem Mikrocontroller, einem sogenannten *field programmable gate array* (FPGA) oder einem sogenannten *application specific integrated circuit* (ASIC).

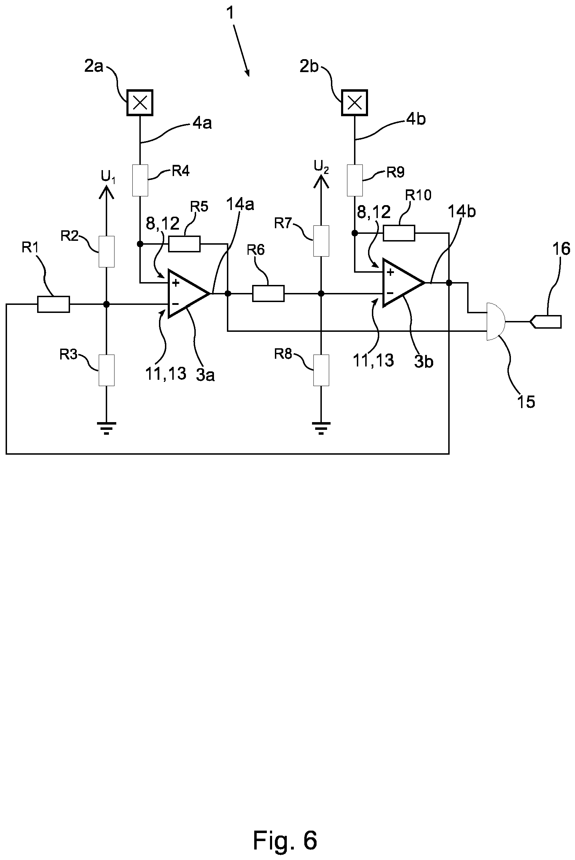

**Fig. 6** zeigt ein analoges Ausführungsbeispiel der erfindungsgemäßen Sensorschaltung 1, bei dem die Auslöseschwellwerte durch elektrische Widerstände voreingestellt bzw. einstellbar sind.

Die redundanten Sensoren 2a, 2b sind über Widerstände R4 bzw. R9 jeweils mit den Messwerteingängen 8 der Vergleichsschaltungen 3a, 3b verbunden, welche als Komparatoren ausgebildet sind.

Die Widerstände R2 und R3 sowie R7 und R8 bilden jeweils einen Spannungsteiler. Über die Referenzspannungen $U_1$ und $U_2$ kann der Auslöseschwellwert für die jeweilige Vergleichsschaltung 3a eingestellt werden.

Die Vergleichsschaltungsausgänge 14a, 14b der Vergleichsschaltungen 3a, 3b sind über die Widerstände R1 bzw. R6 mit dem Referenzeingang 11 (hier einem invertierenden Eingang 13) der jeweils anderen Vergleichsschaltung 3a, 3b verbunden, so dass die entsprechenden Vergleichsschaltungsausgangswerte 17 auf die jeweiligen Referenzeingänge 11 rückgekoppelt sind. Durch Wahl bzw. Einstellung der Widerstände R1 und R6 kann der Skalierungsfaktor der Rückkopplung festgelegt werden.

Die logischen Zustände der Vergleichsschaltungsausgänge 14a, 14b werden in der Verknüpfungseinheit 15 mit einer logischen UND-Operation verknüpft und die Verknüpfungseinheit 15 gibt einen Sensorausgangswert 16 aus, der den durch die UND-Operation erhaltenen logischen Zustand repräsentiert.

Schließlich sind die Sensoren 2a, 2b jeweils direkt über die zusätzlichen Widerstände R5, R10 mit der Verknüpfungseinheit 15 verbunden, was in einer Hysterese des Schaltvorganges resultiert. Mit anderen Worten: Durch die Widerstände R5, R10 wird bewirkt, dass sich der Auslöseschwellwert jedes Sensors zwischen einem Anschaltvorgang (Schalten vom logischen Zustand L=0 in den logischen Zustand L=1) und einem Ausschaltvorgang (Schalten vom logischen Zustand L=1 in den logischen Zustand L=0) zumindest geringfügig unterscheidet.

Beispielsweise kann für einen Anschaltvorgang ein etwas geringerer Auslöseschwellwertvorgesehen sein als für einen Ausschaltvorgang.

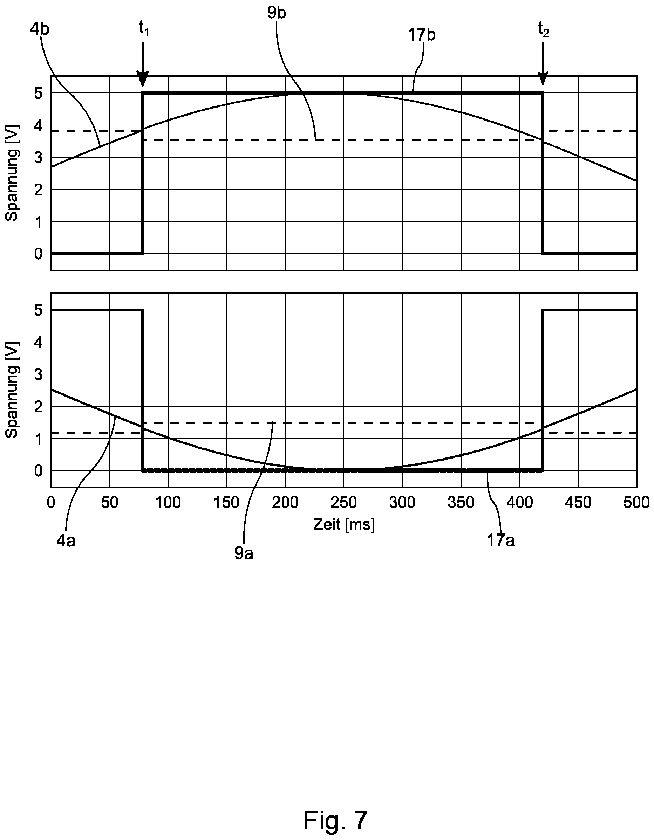

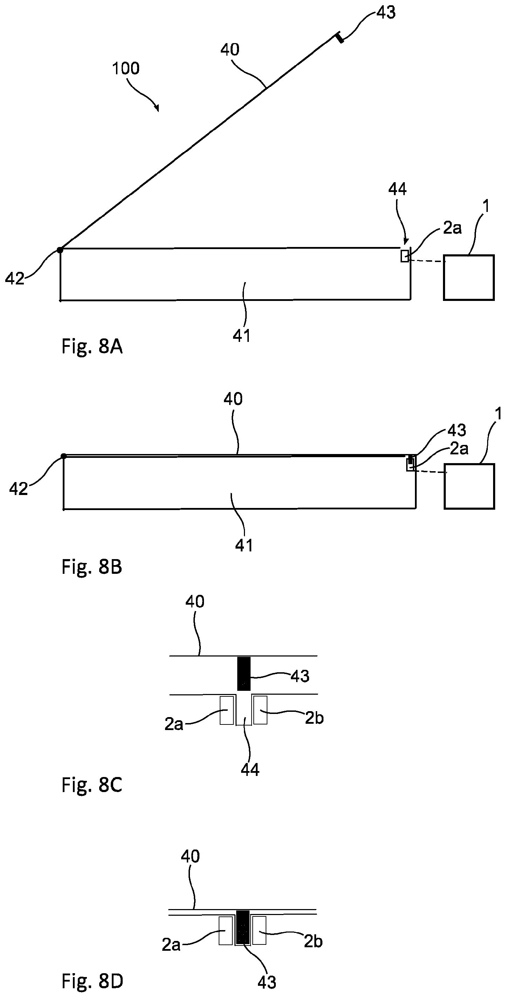

**Fig. 7** zeigt ein Simulationsergebnis einer erfindungsgemäßen Sensorschaltung 1, die beispielsweise zur Überwachung des Öffnungszustands eines Abschirmungselements 40, wie einer Gehäuseabdeckung, verwendet werden kann (siehe Fig. 8). Dazu wird im geschlossenen Zustand der Abdeckung ein Permanentmagnet in einen Spalt zwischen zwei gegenüber angeordneten Hallsensoren 2a, 2b eingeschoben oder eingeschwenkt; beim Öffnen der Geräteabdeckung wird der Magnet aus dem Spalt herausgezogen oder ausgeschwenkt.

Bei geöffneter Abdeckung (d. h. bei ausgeschwenktem Magneten) geben die Hallsensoren 2a, 2b eine Ruhespannung von 2.5 V als Messwert aus, der abhängig von dem dem Sensor 2a, 2b zugewandten Pol des Magneten bei beim Schließen der Abdeckung (d. h. beim Einschwenken der Magneten) bis auf 0 V abfällt (Sensor 2a) bzw. bis auf die Betriebsspannung VCC = 5 V ansteigt (Sensor 2b). Die Sensoren 2a, 2b haben somit antivalente Signalpegel.

Für die Simulation der Sensorschaltung wurde der in **Fig. 6** gezeigte Schaltplan zugrunde gelegt und mit der Schaltungssimulationssoftware Ngspice Version 33 simuliert.

Über die Widerstände R2 und R3 wurde der Auslöseschwellwert für die Vergleichsschaltung 3a auf ca. 1,3 V und für die Vergleichsschaltung 3b auf ca. 3,8 V eingestellt, jeweils bezogen auf den Ruhezustand.

In **Fig. 7** sind Zeit-Spannungs-Kurven für den ersten Sensor 2a und die erste Vergleichsschaltung 3a (unteres Diagramm) sowie für den zweiten Sensor und die zweite Vergleichsschaltung 3b (oberes Diagramm) dargestellt. Die durchgezogenen Kurven stellen den zeitlichen Verlauf der Messwerte 4a, 4b der Sensoren 2a, 2b dar. Die gestrichelten Linien stellen den zeitlichen Verlauf der Auslöseschwellen 9a, 9b der Vergleichsschaltungen 3a, 3b dar. Schließlich ist der zeitliche Verlauf der Vergleichsschaltungsausgangswerte 17a, 17b dargestellt.

Der Vergleichsschaltungsausgangswert 17a 5V der ersten Vergleichsschaltung 3a repräsentiert den logischen Zustand L=0 und der Vergleichsschaltungsausgangswert 17a 0V repräsentiert den logischen Zustand L=1. Umgekehrt repräsentiert der Vergleichsschaltungsausgangswert 17b 0V der zweiten Vergleichsschaltung 3b den logischen Zustand L=0 und der Vergleichsschaltungsausgangswert 17b 5V repräsentiert den logischen Zustand L=1.

Der Messwert 4a des ersten Sensors sinkt von einem Startwert von 2,5 V innerhalb von 250 ms kontinuierlich auf 0V ab und steigt anschließend kontinuierlich innerhalb der gleichen Zeit wieder auf 2,5 V an. Ein solches Verhalten könnte sich z.B. durch schnelles Schließen und anschließendes Wiederöffnen einer Gehäuseabdeckung ergeben, deren Öffnungszustand von einem Hall-Sensor überwacht wird. Entsprechend ergibt sich für den Messwert 4b des antivalenten Sensors 2b (oberes Diagramm) ein Anstieg von 2,5 V auf 5 V innerhalb von 250 ms und ein Wiederabfallen auf 2,5 V innerhalb derselben Zeit.

Am ersten Auslösezeitpunkt $t_1$ überschreitet der Messwert 4b des zweiten Sensors 2b den vorgegebenen Auslöseschwellwert 9b. Dies führt zu einem Schalten der zweiten Vergleichsschaltung 3b in den logischen Zustand L=1, der durch den Vergleichsschaltungsausgangswert 17b von 5 V repräsentiert wird. Infolgedessen steigt der Vergleichs-schaltungsausgangswert 17b zum Zeitpunkt $t_1$ (bzw. je nach Verzögerung der Vergleichsschaltung entsprechend später) sprunghaft von 0 V auf 5 V an.

Das Schalten der zweiten Vergleichsschaltung 3b führt zur Rückkopplung des skalierten Vergleichsschaltungsausgangswertes 17b auf den Messeingang 8 oder Referenzeingang 11 der ersten Vergleichsschaltung 3a und somit zum Anheben des ersten Auslöseschwellwerts 9a (siehe unteres Diagramm).

Der Messwert 4a des ersten Sensors 2a lag am ersten Auslösezeitpunkt $t_1$ noch knapp oberhalb des initial eingestellten Auslöseschwellwerts 9a. Durch die Rückkopplung des anderen Schaltsignals übersteigt jedoch kurz nach dem ersten Auslösezeitpunkt $t_1$ die Auslöseschwelle 9a den Messwert 4a. Es wird also ein Vorzeichenwechsel der Differenz zwischen dem Messwert 4a und der Auslöseschwellwert 9a herbeigeführt, was zu einem Schalten der ersten Vergleichsschaltung 3a führt.

Das Schalten der ersten Vergleichsschaltung 3a führt ebenfalls durch Rückkopplung zu einer Verminderung des Auslöseschwellwerts 9b der zweiten Vergleichsschaltung 3b. Da dieser bereits in den Zustand L=1 geschaltet hat, bewirkt dies jedoch zum ersten Auslösezeitpunkt $t_1$ keine weitere Änderung.

Am zweiten Auslösezeitpunkt $t_2$ erreicht der Messwert 4b des zweiten Sensors 2b wieder den Auslöseschwellwert 9b, während der Messwert 4a des ersten Sensors 2a noch unterhalb seines Auslöseschwellwerts 9a liegt. Somit schaltet zunächst wieder nur die zweite Vergleichsschaltung 3b in den logischen Zustand L=0. Durch die Rückkopplung wird jedoch der Auslöseschwellwert 9a der ersten Vergleichsschaltung 3a vermindert, was erneut in einem Vorzeichenwechsel der Differenz zwischen Messwert 4a und Auslöseschwellwert 9a resultiert. Infolgedessen schaltet auch die erste Vergleichsschaltung 3a in den logischen Zustand L=1.

Aus der Simulation ist also ersichtlich, wie mit der erfindungsgemäßen Sensorschaltung 1 der Auslösezeitpunkt der redundanten Sensoren 2a, 2b unter Beibehaltung der Unabhängigkeit der Sensoren 2a, 2b synchronisiert werden kann.

**Fig. 8** zeigt verschiedene Ansichten einer beispielhaften Vorrichtung 100 mit einer Sensorschaltung 1 gemäß der vorliegenden Erfindung. Dabei sind Fig. 8A und Fig. 8B Seitenansichten der Vorrichtung 100 in verschiedenen Zuständen. Fig. 8C und Fig. 8D zeigen ein Detail der Vorrichtung 1 in unterschiedlichen Zuständen.

Die Vorrichtung 100 weist ein Gehäuse 41 auf, welches interne Komponenten (nicht dargestellt) der Vorrichtung 100 zumindest teilweise umschließt. Über eine Schwenkverbindung 42 ist ein Abschirmungselement 40, z.B. eine Abdeckung, schwenkbar mit dem Gehäuse 41 verbunden. In dem in Fig. 8B gezeigten Zustand deckt das Abschirmungselement 40 die internen Komponenten ab.

Bei den internen Komponenten kann es sich z.B. um bewegliche mechanische Teile wie Wellen, Zahnräder und dergleichen handeln. In diesem Fall fungiert das Abschirmungselement 40 in dem in Fig. 8B gezeigten Zustand als Schutz vor einer Verletzung eines Benutzers durch die mechanischen Teile beim Betrieb der Vorrichtung 100.

Alternativ dazu kann die Vorrichtung 100 auch eine Laservorrichtung sein, die als interne Komponente einen Laser oder einen Strahlengang enthält, in den Laserlicht von einer externen Quelle eingekoppelt wird. Dann verhindert das Abschirmungselement 40 in dem in Fig. 8B gezeigten Zustand den Austritt von Laserlicht aus der Vorrichtung 100 und somit eine mögliche Augenschädigung eines Benutzers.

Die Vorrichtung 100 umfasst weiterhin einen ersten Sensor 2a und einen zweiten Sensor 2b (siehe Fig. 8C und Fig. 8D), welche in redundanter Weise den Zustand des Abschirmungselements 40 überwachen. Gemäß dem in Fig. 8 dargestellten Beispiel handelt es sich bei den Sensoren 2a, 2b um Magnetfeldsensoren, z.B. Hallsensoren. Die Sensoren 2a, 2b sind beidseitig eines Schachts 44 in dem Gehäuse 41 angeordnet und mit einer erfindungsgemäßen Sensorschaltung 1 verbunden, so dass abhängig von dem in dem Schacht 44 wirkenden Magnetfeld Messsignale an die zuvor beschriebenen Komponenten der Sensorschaltung 1 übertragen werden können.

Mit dem Abschirmungselement 40 ist ein Magnet 43 verbunden, der in dem in Fig. 8B und Fig. 8D gezeigten Zustand des Abschirmungselements 40 in dem Schacht 44 angeordnet ist, jedoch in dem in Fig. 8A und Fig. 8C dargestellten Zustand außerhalb des Schachts 44 positioniert ist. Somit wirkt abhängig von dem Zustand des Abschirmungselements 40 ein unterschiedlich starkes Magnetfeld in dem Schacht 44, was durch die Sensoren 2a, 2b messbar ist.

Wenn die Sensorschaltung 1 durch die Auswertung der Messsignale der Sensoren 2a, 2b erkennt, dass sich das Abschirmungselement 40 in einem Zustand befindet, in dem kein ausreichender Schutz für den Benutzer geboten ist (Fig. 8A, Fig. 8C), kann z.B. eine Warnmeldung ausgegeben werden und/oder eine Notabschaltung der Vorrichtung 100 oder ein Übergang in einen sicheren Zustand automatisch eingeleitet werden. Das heißt insbesondere, dass die beweglichen mechanischen Komponenten in der Vorrichtung 100 zum Stillstand gebracht werden oder dass das Laserlicht ausgeschaltet, abgeschirmt oder umgelenkt wird.

**Bezugszeichenliste**

| | |
|---|---|
| 1 | Sensorschaltung |
| 2 | Sensor |
| 2a | Erster Sensor |
| 2b | Zweiter Sensor |
| 3 | Vergleichsschaltung |
| 3a | Erste Vergleichsschaltung |
| 3b | Zweite Vergleichsschaltung |
| 4 | Messwert |
| 4a | Erster Messwert |
| 4b | Zweiter Messwert |
| 5 | Treiber |
| 6 | Verstärkungsfaktor |
| 7 | Skalierer |
| 8 | Messeingang |
| 9 | Auslöseschwellwert |
| 9a | Erster Auslöseschwellwert |
| 9b | Zweiter Auslöseschwellwert |
| 10 | Summierer |
| 10a | Eingang |
| 10b | Ausgang |
| 11 | Referenzeingang |
| 12 | nichtinvertierender Eingang |
| 13 | invertierender Eingang |
| 14 | Vergleichsschaltungsausgang |
| 14a | Erster Vergleichsschaltungsausgang |

| | |
|---|---|
| 14b | Zweiter Vergleichsschaltungsausgang |
| 15 | Verknüpfungseinheit |
| 16 | Schaltungsausgangssignal |
| 17 | Vergleichsschaltungsausgangswert |
| 17a | Erster Vergleichsschaltungsausgangswert |
| 17b | Zweiter Vergleichsschaltungsausgangswert |
| 18 | Analog-Digital-Wandler |
| 19 | Datenleitung |
| 20 | Referenzwert-Register |
| 21 | Dateneingang |
| 22 | Takteingang |
| 23 | Datenausgang |
| 30 | Bias-Register |
| 31 | Dateneingang |
| 32 | Takteingang |
| 33 | *Enable*-Eingang |
| 34 | Datenausgang |
| 40 | Abschirmungselement |
| 41 | Gehäuse |
| 42 | Schwenkverbindung |
| 43 | Magnet |
| 44 | Schacht |
| 50 | Fehlererkennungseinheit |
| 51 | Fehlersignal |
| 100 | Vorrichtung |
| $t_1$ | Erster Auslösezeitpunkt |
| $t_2$ | Zweiter Auslösezeitpunkt |
| $U_1$ | Erste Referenzspannung |
| $U_2$ | Zweite Referenzspannung |

**Patentansprüche**

1. Sensorschaltung (1) für eine eine Sicherheitsfunktion ausführende Vorrichtung (100) umfassend

- mindestens zwei Sensoren (2), wobei jeder der Sensoren (2) dazu ausgebildet ist, eine jeweilige Messgröße (x) zu erfassen und ein Messsignal mit einem von der jeweiligen Messgröße (x) monoton abhängigen Messwert (4) zu erzeugen,
- mindestens zwei Vergleichsschaltungen (3), wobei jede der Vergleichsschaltungen (3) einem der Sensoren (2) zugeordnet ist, und einen Messeingang (8) zum Empfangen des Messsignals des jeweiligen zugeordneten Sensors (2), einen Referenzeingang (11) zum Empfangen eines Referenzsignals zum Festlegen eines Auslöseschwellwerts (9) der Vergleichsschaltung (3) und einen Vergleichsschaltungsausgang (14) aufweist, wobei der Vergleichsschaltungsausgang (14) einen ersten logischen Zustand (L=0) und einen zweiten logischen Zustand (L=1) annehmen kann, und wobei der Vergleichsschaltungsausgang (14) dazu ausgebildet ist, ein Vergleichsschaltungsausgangssignal mit einem einen der logischen Zustände (L=0, L=1) repräsentierenden Vergleichsschaltungsausgangswert (17) zu erzeugen,
- einer Verknüpfungseinheit (15), die dazu ausgebildet ist, die logischen Zustände (L=0, L=1) der Vergleichsschaltungsausgänge (14) mittels einer logischen UND-Operation zu einem Schaltungsausgangssignal (16) der Sensorschaltung (1) zu verknüpfen,
**dadurch gekennzeichnet,**
**dass** die Sensorschaltung (1) dazu ausgebildet ist, den Vergleichsschaltungsausgangswert (17) mindestens eines ersten der Vergleichsschaltungen (3) zu skalieren und auf den Messeingang (8) oder den Referenzeingang (11) mindestens einer zweiten der Vergleichsschaltungen (3) rückzukoppeln, so dass beim Übergang des Vergleichsschaltungsausgangs (14) der ersten Vergleichsschaltung (3) zwischen den logischen Zuständen (L=0, L=1) die Differenz zwischen dem Messsignal und dem Referenzsignal der zweiten Vergleichsschaltung (3) verringert wird oder sich das Vorzeichen der Differenz zwischen dem Messsignal und dem Referenzsignal der zweiten Vergleichsschaltung (3) umkehrt.

2. Sensorschaltung (1) nach Anspruch 1, **dadurch gekennzeichnet, dass** die Sensorschaltung (1) dazu ausgebildet ist, den Vergleichsschaltungsausgangswert (17) der ersten Vergleichsschaltung (3) mit einem Faktor von < 0,5, insbesondere von < 0,2, weiter insbesondere von < 0,1, zu skalieren.

3. Sensorschaltung (1) nach Anspruch 1 oder 2, **dadurch gekennzeichnet, dass** die Sensorschaltung (1) dazu ausgebildet ist, das Referenzsignal der zweiten Vergleichsschaltung (3) durch eine gewichtete Summe aus dem Auslöseschwellwert (9) der zweiten Vergleichsschaltung (3) und dem mit einem Gewichtungsfaktor ($g_{ij}$) gewichteten Vergleichsschaltungsausgangswert (17) der ersten Vergleichsschaltung (3) und optional dem mit einem Gewichtungsfaktor ($g_{ij}$) gewichteten Vergleichsschaltungsausgangswert (17) einer weiteren der Vergleichsschaltungen (3) zu bilden, und/oder dass die Sensorschaltung (1) dazu ausgebildet ist, das Messsignal der zweiten Vergleichsschaltung (3) durch eine gewichtete Summe aus dem Messsignal des der zweiten Vergleichsschaltung (3) zugeordneten Sensors (2) und dem mit einem Gewichtungsfaktor ( $g'_{ij}$ ) gewichteten Vergleichsschaltungsausgangswert (17) der ersten Vergleichsschaltung (3) und optional dem mit einem Gewichtungsfaktor ( $g'_{ij}$ ) gewichteten Vergleichsschaltungsausgangswert (17) mindestens einer weiteren der Vergleichsschaltungen (3) zu bilden.

4. Sensorschaltung (1) nach Anspruch 3, **dadurch gekennzeichnet, dass**

- der bei der Bildung des Referenzsignals aus der gewichteten Summe verwendete Gewichtungsfaktor ($g_{ij}$) kleiner oder gleich Null ist oder der bei der Bildung des Messsignals durch die gewichtete Summe verwendete Gewichtungsfaktor ( $g'_{ij}$ ) größer oder gleich Null ist, wenn der Vergleichsschaltungsausgangswert (17) der ersten Vergleichsschaltung (3) in dem ersten logischen Zustand (L=0) kleiner ist als in dem zweiten logischen Zustand (L=1) und der Messwert (4) des der zweiten Vergleichsschaltung (3) zugeordneten Sensors (2) in Abhängigkeit der Messgröße (x) monoton steigt oder wenn der Vergleichsschaltungsausgangswert (17) der ersten Vergleichsschaltung (3) in dem ersten logischen Zustand (L=0) größer ist als in dem zweiten logischen Zustand (L=1) und der Messwert (4) des der zweiten Vergleichsschaltung (3) zugeordneten Sensors (2) in Abhängigkeit der Messgröße monoton fällt, und/oder
- der bei der Bildung des Referenzsignals aus der gewichteten Summe verwendete Gewichtungsfaktor ($g_{ij}$) größer oder gleich Null ist oder der bei der Bildung des Messsignals durch die gewichtete Summe verwendete Gewichtungsfaktor ( $g'_{ij}$ ) kleiner oder gleich Null ist, wenn der Vergleichsschaltungsausgangswert (17) der ersten Vergleichsschaltung (3) in dem ersten logischen Zustand (L=0) größer ist als in dem zweiten logischen Zustand (L=1) und der Messwert (4) des der zweiten Vergleichsschaltung (3) zugeordneten Sensors (2) in Abhängigkeit der Messgröße (x) monoton steigt oder wenn der Vergleichsschaltungsausgangswert (17) der ersten Vergleichsschaltung (3) in dem ersten logischen Zustand (L=0) kleiner ist als in dem zweiten logischen Zustand (L=1) und der Messwert (4) des der zweiten Vergleichsschaltung (3) zugeordneten Sensors (2) in Abhängigkeit der Messgröße (x) monoton fällt.

5. Sensorschaltung (1) nach einem der vorhergehenden Ansprüche, **dadurch gekennzeichnet, dass** der erste logische Zustand (L=0) und der zweite logische Zustand (L=1) durch elektrische Signalpegel, insbesondere durch TTL-, LVTTL-, CMOS-, ECL-, PECL-, LVECL-, LVPECL- oder LVDS-Signalpegel, oder durch optische Signalzustände, insbesondere durch Intensitäts-, Wellenlängen- oder Polarisationszustände, repräsentiert sind.

6. Sensorschaltung (1) nach Anspruch 5, **dadurch gekennzeichnet, dass** logisch gleiche logische Zustände der Vergleichsschaltungsausgänge (14) verschiedener der Vergleichsschaltungen (3) durch unterschiedliche, insbesondere komplementäre, Signalpegel bzw. optische Signalzustände repräsentiert sind.

7. Sensorschaltung (1) nach einem der vorhergehenden Ansprüche, **dadurch gekennzeichnet, dass** die Messwerte (4) durch analoge Spannungs- oder Stromwerte oder durch Zahlen in einer binären Darstellung repräsentiert sind.

8. Sensorschaltung (1) nach einem der vorhergehenden Ansprüche, **dadurch gekennzeichnet, dass** die Messgrößen (x) unabhängig voneinander ausgewählt sind aus der Gruppe: mechanischer Weg, mechanische Kraft, Druck, Lichtintensität, Polarisation, Temperatur, Lautstärke, Kapazität, Induktivität, magnetischer Fluss, elektrische Spannung, elektrischer Strom oder elektrische Feldstärke.

9. Sensorschaltung (1) nach einem der vorhergehenden Ansprüche, **dadurch gekennzeichnet, dass** die Sensoren (2) unabhängig voneinander gewählt sind aus der Gruppe: Hallsensoren, Fotodioden, Fototransistoren, Fotowiderstände, Thermoelemente, kapazitive oder induktive Abstandssensoren, Dehnungsmessstreifen, Mikrofone, einstellbare Widerstände, einstellbare Kondensatoren, einstellbare Induktivitäten.

10. Sensorschaltung (1) nach einem der vorhergehenden Ansprüche, **dadurch gekennzeichnet, dass** die Sensoren (2) dazu ausgebildet sind, unterschiedliche Messgrößen (x) zu erfassen oder dass die Sensoren (2) dazu ausgebildet sind, die gleiche Messgröße (x) zu erfassen, aber auf unterschiedlichen Messprinzipien beruhen oder unterschiedliche Sensortypen sind.

11. Sensorschaltung (1) nach einem der vorhergehenden Ansprüche, **dadurch gekennzeichnet, dass** die Sensorschaltung (1) eine Fehlererkennungseinheit (50) aufweist, wobei die Fehlererkennungseinheit (50) dazu ausgebildet ist, die logischen Zustände (L=0, L=1) der Vergleichsschaltungsausgänge (14) mittels einer logischen Exklusiv-ODER-Operation zu einem Fehlersignal (51) der Sensorschaltung (1) zu verknüpfen.

12. Vorrichtung (100) zum Ausführen einer Sicherheitsfunktion umfassend eine Sensorschaltung nach einem der Ansprüche 1 bis 11, wobei die Vorrichtung (100) eine Maschine mit einem Abschirmungselement (40) zum Schutz vor einer Berührung elektrisch, pneumatisch oder hydraulisch angetriebener Elemente ist, und wobei die Sensorschaltung (1) dazu ausgebildet ist, einen Zustand des Abschirmungselements (40) zu überwachen.

13. Vorrichtung (100) zum Ausführen einer Sicherheitsfunktion umfassend eine Sensorschaltung nach einem der Ansprüche 1 bis 11, wobei die Vorrichtung (100) eine Laservorrichtung ist, und wobei die Laservorrichtung umfasst

   - einen Laser der Laserklasse 3, 3B, 3R oder 4 und
   - ein Abschirmungselement (40) zum Schutz vor einem Austritt von Laserstrahlung aus der Laservorrichtung und/oder
   - ein in verschiedene Einstellpositionen bewegliches optisches Element und
   - wobei die Sensorschaltung (1) dazu ausgebildet ist, einen Zustand des Abschirmungselements (40) oder des beweglichen optischen Elements zu überwachen.

14. Lichtmikroskop umfassend eine Sensorschaltung (1) nach einem der Ansprüche 1 bis 11 und/oder eine Vorrichtung (100) nach Anspruch 13.

15. Verfahren zum Verarbeiten von Messwerten (4) von Sensoren (2) für eine eine Sicherheitsfunktion ausführende Vorrichtung (100), umfassend die Schritte

   - Erfassen einer jeweiligen Messgröße (x) und Erzeugen eines jeweiligen Messsignals mit einem von der jeweiligen Messgröße (x) monoton abhängigen Messwert (4) mittels mindestens zwei Sensoren (2),
   - Empfangen der Messsignale durch jeweilige Messwerteingänge (8) von mindestens zwei Vergleichsschaltungen (3), wobei jede der Vergleichsschaltungen (3) einem der Sensoren (2) zugeordnet ist,
   - Empfangen von Referenzsignalen zum Festlegen eines Auslöseschwellwerts (9) durch jeweilige Referenzwerteingänge (11) der Vergleichsschaltungen (3),
   - Ausgeben von Vergleichsschaltungsausgangssignalen durch jeweilige Vergleichsschaltungsausgänge (14) der Vergleichsschaltungen (3), wobei die Vergleichsschaltungsausgänge (14) jeweils einen ersten logischen Zustand (L=0) und einen zweiten logischen Zustand (L=1) annehmen können, wobei die Vergleichsschaltungsausgangssignale jeweils einen Vergleichsschaltungsausgangswert (17) aufweisen, der einen der logischen Zustände (L=0, L=1) repräsentiert,
   - Verknüpfen der logischen Zustände (L=0, L=1) der Vergleichsschaltungsausgänge zu einem Schaltungsausgangssignal (16) mittels einer logischen UND-Operation,
   **dadurch gekennzeichnet, dass**
   - der Vergleichsschaltungsausgangswert (17) mindestens einer ersten der Vergleichsschaltungen (3) skaliert und auf den Messeingang (8) oder den Referenzeingang (11) mindestens einer zweiten der Vergleichsschaltungen (3) rückgekoppelt wird, so dass beim Übergang des Vergleichsschaltungsausgangs (14) der ersten Vergleichsschaltung (3) zwischen den logischen Zuständen (L=0, L=1) die Differenz zwischen dem Messsignal und dem Referenzsignal der zweiten Vergleichsschaltung (3) verringert wird oder sich das Vorzeichen der Differenz zwischen dem Messwertwertsignal und dem Referenzsignal der zweiten Vergleichsschaltung (3) umkehrt.

**Claims**

1. A sensor circuit (1) for a device (100) performing a safety function comprising

    - at least two sensors (2), wherein each of the sensors (2) is configured to detect a respective measured variable (x) and to generate a measurement signal comprising a measurement value (4) which is monotonically dependent on the respective measured variable (x),
    - at least two comparison circuits (3), wherein each of the comparison circuits (3) is assigned to one of the sensors (2) and comprises a measurement input (8) for receiving the measurement signal of the respective assigned sensor (2), a reference input (11) for receiving a reference signal to define a trigger threshold value (9) of the comparison circuit (3), and a comparison circuit output (14), wherein the comparison circuit output (14) can assume a first logic state (L=0) and a second logic state (L=1), and wherein the comparison circuit output (14) is configured to generate a comparison circuit output signal comprising a comparison circuit output value (17) representing one of the logic states (L=0, L=1),
    - a linking unit (15) which is configured to combine the logic states (L=0, L=1) of the comparison circuit outputs (14) by means of a logic AND operation to form a circuit output signal (16) of the sensor circuit (1),
    **characterized in that**
    the sensor circuit (1) is configured to scale the comparison circuit output value (17) of at least a first one of the comparison circuits (3) and to feed back the comparison circuit output value (17) to the measurement input (8) or the reference input (11) of at least a second one of the comparison circuits (3), so that, when the comparison circuit output (14) of the first comparison circuit (3) transitions between the logic states (L=0, L=1), the difference between the measurement signal and the reference signal of the second comparison circuit (3) is reduced or the sign of the difference between the measurement signal and the reference signal of the second comparison circuit (3) is reversed.

2. The sensor circuit (1) according to claim 1, **characterized in that** the sensor circuit (1) is configured to scale the comparison circuit output value (17) of the first comparison circuit (3) with a factor of < 0.5, in particular of < 0.2, further in particular of < 0.1.

3. The sensor circuit (1) according to claim 1 or 2, **characterized in that** the sensor circuit (1) is configured to generate the reference signal of the second comparison circuit (3) by a weighted sum of the trigger threshold value (9) of the second comparison circuit (3) and the comparison circuit output value (17) of the first comparison circuit (3) weighted by a weighting factor ($g_{ij}$) and optionally the comparison circuit output value (17) of a further one of the comparison circuits (3) weighted by a weighting factor ($g_{ij}$), and/or **in that** the sensor circuit (1) is configured to generate the measurement signal of the second comparison circuit (3) by a weighted sum of the measurement signal of the sensor (2) assigned to the second comparison circuit (3) and the comparison circuit output value (17) of the first comparison circuit (3) weighted by a weighting factor ( $g'_{ij}$ ) and optionally the comparison circuit output value (17) of at least a further one of the comparison circuits (3) weighted by a weighting factor ( $g'_{ij}$ ).

4. The sensor circuit (1) according to claim 3, **characterized in that**

    - the weighting factor ($g_{ij}$) used in generating the reference signal from the weighted sum is less than or equal to zero or the weighting factor ( $g'_{ij}$ ) used in generating the measurement signal from the weighted sum is larger than or equal to zero if the comparison circuit output value (17) of the first comparison circuit (3) is smaller in the first logic state (L=0) than in the second logic state (L=1) and the measurement value (4) of the sensor (2) assigned to the second comparison circuit (3) increases monotonically as a function of the measured variable (x) or if the comparison circuit output value (17) of the first comparison circuit (3) is greater in the first logic state (L=0) than in the second logic state (L=1) and the measurement value (4) of the sensor (2) assigned to the second comparison circuit (3) falls monotonically as a function of the measured variable, and/or
    - the weighting factor ($g_{ij}$) used in generating the reference signal from the weighted sum is greater than or equal to zero or the weighting factor ( $g'_{ij}$ ) used in generating the measurement signal by the weighted sum is smaller than or equal to zero, if the comparison circuit output value (17) of the first comparison circuit (3) is larger in the first logic state (L=0) than in the second logic state (L=1) and the measurement value (4) of the sensor (2) assigned to the second comparison circuit (3) increases monotonically as a function of the measured variable (x) or if the comparison circuit output value (17) of the first comparison circuit (3) is smaller in the first logic state (L=0) than in the second logic state (L=1) and the measurement value (4) of the sensor (2) assigned to the second comparison circuit (3) falls monotonically as a function of the measured variable (x).

5. The sensor circuit (1) according to one of the preceding claims, **characterized in that** the first logic state (L=0) and the second logic state (L=1) are represented by electrical signal levels, in particular by TTL, LVTTL, CMOS, ECL, PECL, LVECL, LVPECL or LVDS signal levels, or by optical signal states, in particular by intensity, wavelength or polarization states.

6. The sensor circuit (1) according to claim 5, **characterized in that** logically identical logic states of the comparison circuit outputs (14) of different ones of the comparison circuits (3) are represented by different, in particular complementary, signal levels or optical signal states.

7. The sensor circuit (1) according to one of the preceding claims, **characterized in that** the measurement values (4) are represented by analog voltage or current values, or by numbers in a binary representation.

8. The sensor circuit (1) according to one of the preceding claims, **characterized in that** the measured variables (x) are independently selected from the group: mechanical displacement, mechanical force, pressure, light intensity, polarization, temperature, loudness, capacitance, inductance, magnetic flux, electric voltage, electric current or electric field strength.

9. The sensor circuit (1) according to one of the preceding claims, **characterized in that** the sensors (2) are independently selected from the group: hall sensors, photodiodes, phototransistors, photoresistors, thermocouples, capacitive or inductive distance sensors, strain gauges, microphones, adjustable resistors, adjustable capacitors, adjustable inductors.

10. The sensor circuit (1) according to one of the preceding claims, **characterized in that** the sensors (2) are configured to detect different measurement variables (x), or that the sensors (2) are configured to detect the same measurement variable (x), but are based on different measuring principles or are different sensor types.

11. The sensor circuit (1) according to one of the preceding claims, **characterized in that** the sensor circuit (1) comprises a fault detection unit (50), wherein the fault detection unit (50) is configured to link the logic states (L=0, L=1) of the comparison circuit outputs (14) by means of a logic exclusive-OR operation to form a fault signal (51) of the sensor circuit (1).

12. A device (100) for performing a safety function comprising a sensor circuit (1) according to one of claims 1 to 11, wherein the device (100) is a machine comprising a shielding element (40) for protecting against contact of electrically, pneumatically or hydraulically driven elements, and wherein the sensor circuit (1) is configured to monitor a state of the shielding element (40).

13. A device (100) for performing a safety function comprising a sensor circuit (1) according to one of claims 1 to 11, wherein the device (100) is a laser device, and wherein the laser device comprises

   - a laser of laser class 3, 3B, 3R or 4 and
   - a shielding element (40) for protection against laser radiation escaping from the laser device and/or
   - an optical element that can be moved into various adjustment positions, and
   - wherein the sensor circuit (1) is configured to monitor a state of the shielding element (40) or the movable optical element.

14. A light microscope comprising a sensor circuit (1) according to one of claims 1 to 11 and/or a device (100) according to claim 13.

15. A method for processing measurement values (4) from sensors (2) for a device (100) performing a safety function, comprising the steps of

   - detecting a respective measured variable (x) and generating a respective measurement signal comprising a measurement value (4) which is monotonically dependent on the respective measured variable (x) by means of at least two sensors (2),
   - receiving the measurement signals by respective measurement inputs (8) of at least two comparison circuits (3), wherein each of the comparison circuits (3) are associated with one of the sensors (2),

- receiving reference signals for setting a trigger threshold value (9) by respective reference inputs (11) of the comparison circuits (3),

- outputting comparison circuit output signals by respective comparison circuit outputs (14) of said comparison circuits (3), wherein the comparison circuit outputs (14) are each capable of assuming a first logic state (L=0) and a second logic state (L=1), wherein the comparison circuit output signals each comprise a comparison circuit output value (17) representing one of said logic states (L=0, L=1),

- combining the logic states (L=0, L=1) of the comparison circuit outputs to a circuit output signal (16) by means of a logical AND operation,

**characterized in that**

- the comparison circuit output value (17) of at least a first one of the comparison circuits (3) is scaled and fed back to the measurement input (8) or the reference input (11) of at least a second one of the comparison circuits (3), so that during the transition of the comparison circuit output (14) of the first comparison circuit (3) between the logic states (L=0, L=1), the difference between the measurement signal and the reference signal of the second comparison circuit (3) is reduced or the sign of the difference between the measurement signal and the reference signal of the second comparison circuit (3) is reversed.

**Revendications**

1. Circuit de détection (1) pour un dispositif (100) exécutant une fonction de sécurité, comprenant

- au moins deux capteurs (2), chacun des capteurs (2) étant conçu pour détecter une grandeur de mesure respective (x) et pour générer un signal de mesure avec une valeur de mesure (4) dépendant de manière monotone de la grandeur de mesure respective (x)

- au moins deux circuits de comparaison (3), chacun des circuits de comparaison (3) étant associé à l'un des capteurs (2) et présentant une entrée de mesure (8) pour recevoir le signal de mesure du capteur respectif associé (2), une entrée de référence (11) pour recevoir un signal de référence pour fixer une valeur de seuil de déclenchement (9) du circuit de comparaison (3) et une sortie (14) de circuit de comparaison, dans lequel la sortie (14) de circuit de comparaison peut prendre un premier état logique (L=0) et un deuxième état logique (L=1), et dans lequel la sortie (14) de circuit de comparaison est conçue pour produire un signal de sortie de circuit de comparaison ayant une valeur de sortie (17) de circuit de comparaison représentant l'un des états logiques (L=0, L=1)

- une unité de combinaison (15) qui est conçue pour combiner les états logiques (L=0, L=1) des sorties (14) de circuit de comparaison au moyen d'une opération ET logique en un signal de sortie de circuit (16) du circuit de détection (1),

**caractérisé en ce que** le circuit de détection (1) est conçu pour mettre à l'échelle la valeur de sortie (17) de circuit de comparaison d'au moins un premier des circuits de comparaison (3) et pour la réinjecter sur l'entrée de mesure (8) ou sur l'entrée de référence (11) d'au moins un deuxième des circuits de comparaison (3), de sorte que, lors de la transition de la sortie (14) du premier circuit de comparaison (3) entre les états logiques (L=0, L=1), la différence entre le signal de mesure et le signal de référence du deuxième circuit de comparaison (3) est réduite ou le signe de la différence entre le signal de mesure et le signal de référence du deuxième circuit de comparaison (3) est inversé.

2. Circuit de détection (1) selon la revendication 1, **caractérisé en ce que** le circuit de détection (1) est conçu pour mettre à l'échelle la valeur de sortie (17) de circuit de comparaison du premier circuit de comparaison (3) avec un facteur de < 0,5, en particulier de < 0,2, plus particulièrement de < 0,1.

3. Circuit de détection (1) selon la revendication 1 ou 2, **caractérisé en ce que** le circuit de détection (1) est conçu pour former le signal de référence du deuxième circuit de comparaison (3) par une somme pondérée de la valeur de seuil de déclenchement (9) du deuxième circuit de comparaison (3) et de la valeur de sortie (17) de circuit de comparaison du premier circuit de comparaison (3) pondérée par un facteur de pondération ($g_{ij}$) et, en option, de la valeur de sortie (17) de circuit de comparaison d'un autre des circuits de comparaison (3) pondérée par un facteur de pondération ($g_{ij}$), et/ou **en ce que** le circuit de détection (1) est conçu pour former le signal de mesure du deuxième circuit de comparaison (3) par une somme pondérée du signal de mesure du capteur (2) associé au deuxième circuit de comparaison (3) et de la valeur de sortie (17) de circuit de comparaison du premier circuit de comparaison (3) pondérée par un facteur de pondération ($g'_{ij}$) et, en option, de la valeur de sortie (17) de circuit de comparaison d'au moins un autre des circuits de comparaison (3) pondérée par un facteur de pondération ($g'_{ij}$).

4. Circuit de détection (1) selon la revendication 3, **caractérisé en ce que**

- le facteur de pondération ($g_{ij}$) utilisé lors de la formation du signal de référence à partir de la somme pondérée est inférieur ou égal à zéro ou le facteur de pondération ($g'_{ij}$) utilisé lors de la formation du signal de mesure par la somme pondérée est supérieur ou égal à zéro, lorsque la valeur de sortie (17) du circuit de comparaison du premier circuit de comparaison (3) est plus petite dans le premier état logique (L=0) que dans le deuxième état logique (L=1) et que la valeur de mesure (4) du capteur (2) associé au deuxième circuit de comparaison (3) augmente de manière monotone en fonction de la grandeur de mesure (x) ou lorsque la valeur de sortie (17) du circuit de comparaison du premier circuit de comparaison (3) est plus grande dans le premier état logique (L=0) que dans le deuxième état logique (L=1) et que la valeur de mesure (4) du capteur (2) associé au deuxième circuit de comparaison (3) diminue de manière monotone en fonction de la grandeur de mesure, et/ou

- le facteur de pondération ($g_{ij}$) utilisé lors de la formation du signal de référence à partir de la somme pondérée est supérieur ou égal à zéro ou le facteur de pondération ($g'_{ij}$) utilisé lors de la formation du signal de mesure par la somme pondérée est inférieur ou égal à zéro, lorsque la valeur de sortie (17) du circuit de comparaison du premier circuit de comparaison (3) est plus grande dans le premier état logique (L=0) que dans le deuxième état logique (L=1) et que la valeur de mesure (4) du capteur (2) associé au deuxième circuit de comparaison (3) augmente de manière monotone en fonction de la grandeur de mesure (x) ou lorsque la valeur de sortie (17) du circuit de comparaison de premier circuit de comparaison (3) est plus petite dans le premier état logique (L=0) que dans le deuxième état logique (L=1) et que la valeur de mesure (4) du capteur (2) associé au deuxième circuit de comparaison (3) diminue de manière monotone en fonction de la grandeur de mesure (x).

5. Circuit de détection (1) selon l'une des revendications précédentes, **caractérisé en ce que** le premier état logique (L=0) et le deuxième état logique (L=1) sont représentés par des niveaux de signaux électriques, en particulier des niveaux de signaux TTL, LVTTL, CMOS, ECL, PECL, LVECL, LVPECL ou LVDS, ou par des états de signaux optiques, en particulier des états d'intensité, de longueur d'onde ou de polarisation.

6. Circuit de détection (1) selon la revendication 5, **caractérisé en ce que** des états logiques logiquement identiques des sorties (14) de circuit de comparaison de différents des circuits de comparaison (3) sont représentés par des niveaux de signal ou des états de signal optique différents, en particulier complémentaires.

7. Circuit de détection (1) selon l'une des revendications précédentes, **caractérisé en ce que** les valeurs de mesure (4) sont représentées par des valeurs analogiques de tension ou de courant ou par des nombres dans une représentation binaire.

8. Circuit de détection (1) selon l'une des revendications précédentes, **caractérisé en ce que** les grandeurs de mesure (x) sont choisies indépendamment les unes des autres dans le groupe: déplacement mécanique, force mécanique, pression, intensité lumineuse, polarisation, température, volume sonore, capacité, inductance, flux magnétique, tension électrique, courant électrique ou intensité de champ électrique.

9. Circuit de détection (1) selon l'une des revendications précédentes, **caractérisé en ce que** les capteurs (2) sont choisis indépendamment les uns des autres dans le groupe: capteurs à effet Hall, photodiodes, phototransistors, photorésistances, thermocouples, capteurs de distance capacitifs ou inductifs, jauges de contrainte, microphones, résistances réglables, condensateurs réglables, inductances réglables.

10. Circuit de détection (1) selon l'une des revendications précédentes, **caractérisé en ce que** les capteurs (2) sont conçus pour détecter différentes grandeurs de mesure (x) ou **en ce que** les capteurs (2) sont conçus pour détecter la même grandeur de mesure (x), mais reposent sur des principes de mesure différents ou sont des types de capteurs différents.

11. Circuit de détection (1) selon l'une des revendications précédentes, **caractérisé en ce que** le circuit de détection (1) comporte une unité de détection d'erreur (50), l'unité de détection d'erreur (50) étant conçue pour combiner les états logiques (L=0, L=1) des sorties (14) de circuit de comparaison au moyen d'une opération logique OU exclusif pour former un signal d'erreur (51) du circuit de détection (1).

**12.** Dispositif (100) pour exécuter une fonction de sécurité comprenant un circuit de détection selon l'une des revendications 1 à 11, dans lequel le dispositif (100) est une machine avec un élément de blindage (40) pour la protection contre un contact avec des éléments entraînés électriquement, pneumatiquement ou hydrauliquement, et dans lequel le circuit de détection (1) est adapté pour surveiller un état de l'élément de blindage (40).

**13.** Dispositif (100) pour exécuter une fonction de sécurité comprenant un circuit de détection selon l'une quelconque des revendications 1 à 11, dans lequel le dispositif (100) est un dispositif laser, et dans lequel le dispositif laser comprend

- un laser de classe 3, 3B, 3R ou 4, et
- un élément de blindage (40) pour la protection contre la sortie du rayonnement laser du dispositif laser et/ou
- un élément optique pouvant être déplacé dans différentes positions de réglage; et
- dans lequel le circuit de détection (1) est adapté pour surveiller un état de l'élément de blindage (40) ou de l'élément optique mobile.

**14.** Microscope optique comprenant un circuit de détection (1) selon l'une des revendications 1 à 11 et/ou un dispositif (100) selon la revendication 13.

**15.** Procédé de traitement de valeurs de mesure (4) de capteurs (2) pour un dispositif (100) exécutant une fonction de sécurité, comprenant les étapes suivantes

- détection d'une grandeur de mesure respective ($x$) et production d'un signal de mesure respectif avec une valeur de mesure (4) dépendant de manière monotone de la grandeur de mesure respective ($x$) au moyen d'au moins deux capteurs (2),
- réception des signaux de mesure par des entrées de valeurs de mesure respectives (8) d'au moins deux circuits de comparaison (3), chacun des circuits de comparaison (3) étant associé à l'un des capteurs (2),
- réception de signaux de référence pour établir un seuil de déclenchement (9) par des entrées de valeur de référence respectives (11) des circuits de comparaison (3),
- émettre des signaux de sortie de circuit de comparaison par des sorties (14) de circuit de comparaison respectives des circuits de comparaison (3), les sorties (14) de circuit de comparaison pouvant prendre respectivement un premier état logique (L=0) et un deuxième état logique (L=1), les signaux de sortie de circuit de comparaison comprenant chacun une valeur de sortie de circuit de comparaison représentant l'un des états logiques (L=0, L=1),
- combiner les états logiques (L=0, L=1) des sorties de circuit de comparaison en un signal de sortie de circuit (16) au moyen d'une opération logique ET,
**caractérisé en ce que**
- la valeur de sortie (17) du circuit de comparaison d'au moins un premier des circuits de comparaison (3) est mise à l'échelle et réinjectée sur l'entrée de mesure (8) ou sur l'entrée de référence (11) d'au moins un deuxième des circuits de comparaison (3), de sorte que lors de la transition de la sortie (14) du circuit de comparaison du premier circuit de comparaison (3) entre les états logiques (L=0, L=1), la différence entre le signal de mesure et le signal de référence du deuxième circuit de comparaison (3) est réduite ou le signe de la différence entre le signal de valeur de mesure et le signal de référence du deuxième circuit de comparaison (3) est inversé.

Fig. 1

Fig. 2

Fig. 3

Fig. 4

Fig. 5

Fig. 6

Fig. 7

Fig. 8A

Fig. 8B

Fig. 8C

Fig. 8D

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4088900 A
- US 20050052083 A1
- DE 4315298 C1
- EP 0164118 B1
- DE 10330202
- DE 102013108532 A1
- US 20200195186 A1
- DE 1537379 A1